# EUROPEAN PATENT SPECIFICATION

(11) **EP 4 576 466 B1**
(45) Date of publication and mention of the grant of the patent: **14.10.2026**
(21) Application number: 24221523.4
(22) Date of filing: 19.12.2024
(51) Int. Cl.: H02H 3/087, H02H 3/10, H02H 7/122, H02M 1/32, H02H 3/32, H02H 3/34, H02M 7/5387, H02H 3/02, H02H 3/033, H02H 3/24

(54) **PROTECTION CIRCUIT, CONTROL METHOD AND PHOTOVOLTAIC SYSTEM**
SCHUTZSCHALTUNG, STEUERUNGSVERFAHREN UND FOTOVOLTAISCHES SYSTEM
CIRCUIT DE PROTECTION, PROCÉDÉ DE COMMANDE ET SYSTÈME PHOTOVOLTAÏQUE

(30) Priority: 21.12.2023 CN 202311774148; 12.08.2024 CN 202411106575
(43) Date of publication of application: 25.06.2025
(73) Proprietor: Shanghai Sigeyuan Intelligent Technology Co., Ltd, Shanghai 200120 (CN)
(72) Inventor: TANG, Lin, Shanghai, 200120 (CN); HUANG, Wenzhan, Shanghai, 200120 (CN)
(74) Representative: Bayramoglu et al.

(56) References cited:
- WO-A1-2022/126351
- CN-A- 105 548 755
- CN-A- 115 664 240
- CN-A- 117 039 807
- CN-B- 113 629 988
- US-A1- 2023 208 312

## Description

### TECHNICAL FIELD

The present invention belongs to the technical field of power electronics, and particularly relates to a protection circuit, a control method and a photovoltaic system.

### BACKGROUND TECHNOLOGY

The photovoltaic system usually includes a photovoltaic assembly and an inverter. The photovoltaic assembly is a large-area solar panel formed by connecting solar panels in series and encapsulating the solar panels. The photovoltaic assembly can convert solar energy into a direct current (DC), and then the inverter is configured to convert the DC of the photovoltaic assembly into an alternating current (AC), which can be directly merged into a power grid or directly supplied to electrical appliances.

In actual engineering, cables of the photovoltaic system are easily damaged due to construction or severe environments, thereby causing the short-to-ground (STG) of the photovoltaic cables. The STG of the photovoltaic cables will generate a kiloampere-level short-circuit current, which is highly risky to damage components in the circuit.

CN115664240A discloses an inverter protection device and a photovoltaic system, and provides an inverter, a photovoltaic system and a control method, and the inverter comprises a power conversion circuit, a controller and a current detection device. The power conversion circuit comprises at least one bridge arm and a controllable switch tube, each bridge arm comprises an upper bridge arm and a lower bridge arm, the upper bridge arm and the lower bridge arm are connected in series between an input positive end and an input negative end, the upper bridge arm comprises a first switch module, and the lower bridge arm comprises a second switch module; the controllable switch tube is connected with at least one of the upper bridge arm and the lower bridge arm in parallel, and the conduction direction of the controllable switch tube in the conduction state is the same as the conduction direction of the diodes in the upper bridge arm and the lower bridge arm. The controller controls the controllable switch tube to be switched on, current flowing through the diodes in the upper bridge arm or the lower bridge arm is shunted. US2023/208312A1 discloses a converter, which includes a power conversion circuit, a switching device, and a controller, and includes N phases, where N is 2 or 3. An input end of the power conversion circuit is connected to a direct current power supply, and the power conversion circuit converts a direct current output by the direct current power supply into an alternating current. The switching device includes at least the following two stages: a first-stage switching device and a second-stage switching device. The first-stage switching device and the second-stage switching device separately include N switches, and the N switches are connected in series to the N phases respectively. An output end of the power conversion circuit is connected to an alternating current power grid through the first-stage switching device and the second-stage switching device that are connected in series. CN105548755A discloses a method of detecting inverter AC and DC-side grounding through a single grounding insulation impedance detection network. The method comprises steps: a grounding insulation impedance detection network is only added to the input side of a solar array, and waveforms of the DC-side array positive electrode grounding voltage VPV+PE and the negative electrode grounding voltage VPV-PE are detected; or, the grounding insulation impedance detection network is only added to the AC output side to detect waveforms of AC-side three-phase grounding voltage VA-PE, VB-PE and VC-PE; and as for the former, AC components in the waveforms are extracted to judge the AC-side grounding condition, and as for the latter, DC components in the waveforms are extracted to judge the DC-side grounding condition. CN113629988B discloses a PWM rectifier and a short-circuit protection device thereof. The short-circuit protection device of the PWM rectifier comprises an AC/DC circuit arranged between an AC side and a DC side of the PWM rectifier; when the direct current side of the PWM rectifier is short-circuited, the AC/DC circuit is in a conducting state, and bypasses part of short-circuit current flowing through a diode which is in inverse parallel connection with an IGBT in the PWM rectifier; namely, the AC/DC circuit in the short-circuit protection device of the PWM rectifier can conduct the short-circuit current flowing through the IGBT anti-parallel diode in the PWM rectifier through the bypass part when the DC side of the PWM rectifier is short-circuited. WO2022/126351A1 discloses a photovoltaic system, a protection method, and an inverter system. Said system comprises: a controller and two sets of inverters; the two sets of inverters comprise a positive inverter set and a negative inverter set. The positive inverter set comprises at least two inverters: a first inverter and a third inverter. The negative inverter set comprises at least two inverters: a second inverter and a fourth inverter. The alternating current (AC) output ends of the first inverter and the third inverter are connected in parallel, and the direct current (DC) input ends of the first inverter and the second inverter are connected in series; the AC output ends of the second inverter and the fourth inverter are connected in parallel; the DC input ends of the third inverter and the fourth inverter are connected in series. The controller obtains the circulating current between the at least two inverters of which the AC output ends are connected in parallel, the circulating current is greater than a preset current threshold or the rising rate of the circulating current is greater than a preset rate, and all the inverters of which corresponding AC output ends are connected in parallel are controlled to be turned off. CN117039807A discloses an inverter system, a grid-connected system and an inverter protection method. The inverter system comprises a power conversion circuit, a protection circuit, a detection circuit and a controller, when the inverter system is a three-phase system, the protection circuit comprises at least two bidirectional controllable switch modules; two ends of the bidirectional controllable switch module are respectively connected between different phases of the output end of the power conversion circuit; when the inverter system is a single-phase system, the protection circuit comprises at least one bidirectional controllable switch module; the detection circuit is used for detecting an input parameter and/or an output parameter of the power conversion circuit, and sending fault information to the controller when judging that the power conversion circuit fails according to the input parameter and/or the output parameter; and the controller is used for controlling the bidirectional controllable switch module to be switched on when the fault information is received, so that the line voltage is short-circuited.

### CONTENT OF THE INVENTION

The present invention is intended to solve at least one of the technical problems existing in the prior art. In view of this, the present invention provides a protection circuit, a control method and a photovoltaic system. The present invention not only can disconnect the relay safely, but also can cut off the loop of the short-circuit current, thereby preventing damage of the short-circuit current on components in the circuit.

According to a first aspect, the present invention provides a protection circuit, where the protection circuit is applied to a three-phase inverter circuit; a DC side of the three-phase inverter circuit is configured to connect a power supply assembly; an output terminal of each phase in the three-phase inverter circuit is provided with a relay assembly; and the protection circuit includes:
a controllable power device in parallel connection with a bridge arm in the three-phase inverter circuit;
a fault detection module electrically connected to the three-phase inverter circuit, and configured to generate a first fault signal when detecting an anode STG fault of the power supply assembly, and/or generate a second fault signal when detecting a cathode STG fault of the power supply assembly;
a current detection circuit electrically connected to the three-phase inverter circuit, and configured to detect an output current of each phase in the three-phase inverter circuit; and
a controller electrically connected to the fault detection module, the current detection circuit and the relay assembly, and configured to control the controllable power device to be on after receiving the first fault signal and/or the second fault signal and disconnect the relay assembly of each phase when the output current of each phase meets a zero-crossing condition;
   wherein the fault detection module comprises: an overcurrent detection module electrically connected to the current detection circuit, and configured to generate a first overcurrent signal at an output terminal of the overcurrent detection module when a negative output current of at least one phase is greater than a first current threshold, and/or generate a second overcurrent signal at the output terminal of the overcurrent detection module when a positive output current of at least one phase is greater than a second current threshold; a common-mode current detection module electrically connected to the DC side of the three-phase inverter circuit, and configured to generate a first common-mode current signal at an output terminal of the common-mode current detection module when a negative common-mode current at the DC side of the three-phase inverter circuit is greater than a third current threshold, and/or generate a second common-mode current signal at the output terminal of the common-mode current detection module when a positive common-mode current at the DC side of the three-phase inverter circuit is greater than a fourth current threshold; a voltage detection module electrically connected to an anode of the power supply assembly, a cathode of the power supply assembly and a ground node, and configured to generate a first voltage-to-ground signal at an output terminal of the voltage detection module when a voltage-to-ground between the anode of the power supply assembly and the ground node is less than a first voltage threshold, and/or generate a second voltage-to-ground signal at the output terminal of the voltage detection module when a voltage-to-ground between the cathode of the power supply assembly and the ground node is less than a second voltage threshold; and a signal conversion module electrically connected to the overcurrent detection module, the common-mode current detection module and the voltage detection module;
wherein the signal conversion module comprises: a first AND gate, wherein input terminals of the first AND gate are respectively and electrically connected to the output terminal of the overcurrent detection module, the output terminal of the common-mode current detection module and the output terminal of the voltage detection module, and an output terminal of the first AND gate is electrically connected to the controller, such that, when three of the first overcurrent signal, the first common-mode current signal, and the first voltage-to-ground signal are present at the input terminals of the first AND gate, the first AND gate is configured to generate the first fault signal at the output terminal of the first AND gate; and when three of the second overcurrent signal, the second common-mode current signal, and the second voltage-to-ground signal are present at the input terminals of the first AND gate, the first AND gate is configured to generate the second fault signal at the output terminal of the first AND gate; or, the signal conversion module comprises: a second AND gate, wherein input terminals of the second AND gate are respectively and electrically connected to the output terminal of the overcurrent detection module and the output terminal of the common-mode current detection module; a third AND gate, wherein input terminals of the third AND gate are respectively and electrically connected to the output terminal of the overcurrent detection module and the output terminal of the voltage detection module; a fourth AND gate, wherein input terminals of the fourth AND gate are respectively and electrically connected to the output terminal of the common-mode current detection module and the output terminal of the voltage detection module; and an OR gate, wherein input terminals of the OR gate are respectively and electrically connected to an output terminal of the second AND gate, an output terminal of the third AND gate and an output terminal of the fourth AND gate, and an output terminal of the OR gate is electrically connected to the controller, such that when any two of the first overcurrent signal, the first common-mode current signal, and the first voltage-to-ground signal are present at the input terminals of at least one of the second AND gate, the third AND gate, and the fourth AND gate, the OR gate is configured to generate the first fault signal at the output terminal of the OR gate; and when any two of the second overcurrent signal, the second common-mode current signal, and the second voltage-to-ground signal are present at the input terminals of at least one of the second AND gate, the third AND gate, and the fourth AND gate, the OR gate is configured to generate the second fault signal at the output terminal of the OR gate.

According to an embodiment of the present invention, the bridge arm includes an upper bridge arm and a lower bridge arm; and
the controller is configured to control the controllable power device in parallel connection with the upper bridge arm to be on when receiving the first fault signal, and/or control the controllable power device in parallel connection with the lower bridge arm to be on when receiving the second fault signal.

According to an embodiment of the present invention, the signal conversion module further includes:
a data filtering unit, the data filtering unit including an input terminal electrically connected to an output terminal of the overcurrent detection module, an output terminal of the common-mode current detection module and an output terminal of the voltage detection module, and configured to filter the first overcurrent signal, the second overcurrent signal, the first common-mode current signal, the second common-mode current signal, the first voltage-to-ground signal and/or the second voltage-to-ground signal.

According to an embodiment of the present invention, the relay assembly includes a plurality of relays connected in series; and the controller is electrically connected to the relays, and configured to use at least two relay disconnecting sequences when disconnecting the relay assembly repeatedly.

The relay assembly includes a first relay and a second relay connected in series; and the controller is configured to execute the following operations alternately:
disconnecting the first relay prior to the second relay; or,
disconnecting the second relay prior to the first relay.

According to an embodiment of the present invention, the controllable power device includes silicon controlled rectifiers (SCRs) corresponding to output phases of the three-phase inverter circuit;
each SCR is provided between the anode of the power supply assembly and the bridge arm of the phase; and when the anode of the power supply assembly is grounded, the controllable power device is started, such that the SCR is turned on to shunt a current from the anode of the power supply assembly to a switching device, wherein the switching device is between the bridge arms of the phases at an AC side of the three-phase inverter circuit; or
each SCR is provided between the cathode of the power supply assembly and the bridge arm of the phase; and when the cathode of the power supply assembly is grounded, the controllable power device is started, such that the SCR is turned on to shunt a current from the cathode of the power supply assembly to a switching device, wherein the switching device is between the bridge arms of the phases at the AC side of the three-phase inverter circuit.

According to an embodiment of the present invention, the controller includes:
a preliminary breaking module configured to enter a preliminary breaking stage after receiving the fault signal, and determine zero-crossing time when the output current of each phase in the three-phase inverter circuit crosses a zero point for a first time; and
a main breaking module configured to enter a main breaking stage after the preliminary breaking stage, and disconnect, when each phase meets at least one of the following conditions, the relay assembly of the corresponding phase:
   a time difference between present time and the zero-crossing time is less than a threshold; or,
   the output current is less than a fifth current threshold.

According to an embodiment of the present invention, the three-phase inverter circuit uses a three-phase four-wire system; and the main breaking module is further configured to enter the main breaking stage after the preliminary breaking stage, and disconnect, when each phase meets at least one of the following conditions, the relay assembly of the corresponding phase:
the time difference between the present time and the zero-crossing time is less than the threshold;
the output current is less than the fifth current threshold; or,
an angle of a phase voltage falls within a target angle range, where
in response to the anode STG fault, the target angle range is [180°, 180+θ₁°]; and in response to the cathode STG fault, the target angle range is [0°, θ₂°], θ₁ being a first angle threshold, and θ₂ being a second angle threshold.

According to a second aspect, the present invention provides a control method for operating a protection circuit as disclosed above, where the control method is applied to a three-phase inverter circuit; a DC side of the three-phase inverter circuit is configured to connect a power supply assembly; an output terminal of each phase in the three-phase inverter circuit is provided with a relay assembly; a bridge arm in the three-phase inverter circuit is in parallel connection with a controllable power device; and the control method includes:
controlling the controllable power device to be on when detecting an STG fault of the power supply assembly;
detecting an output current of each phase in the three-phase inverter circuit; and
disconnecting the relay assembly of each phase after the controllable power device is turned on and when the output current of each phase meets a zero-crossing condition.

According to an embodiment of the present invention, the disconnecting the relay assembly of each phase when the output current of each phase meets a zero-crossing condition includes:
in a first stage, determining zero-crossing time when the output current of each phase in the three-phase inverter circuit crosses a zero point for a first time; and
in a second stage, when each phase meets at least one of the following conditions, disconnecting the relay assembly of the corresponding phase:
   a time difference between present time and the zero-crossing time is less than a threshold; or,
   the output current is less than a fifth current threshold.

According to an embodiment of the present invention, the three-phase inverter circuit uses a three-phase four-wire system, and the control method further includes:
acquiring an angle of each phase voltage; and
in the second stage, when each phase meets at least one of the following conditions, disconnecting the relay assembly of the corresponding phase:
   the time difference between the present time and the zero-crossing time is less than the threshold;
   the output current is less than the fifth current threshold; or,
   the angle of the phase voltage falls within a target angle range, where
   in response to an anode STG fault, the target angle range is [180°, 180+θ₁°]; and in response to a cathode STG fault, the target angle range is [0°, θ₂°], θ₁ being a first angle threshold, and θ₂ being a second angle threshold.

According to an embodiment of the present invention, the bridge arm of the three-phase inverter circuit includes an upper bridge arm; and the controlling the controllable power device to be on when detecting an STG fault includes:
When the first fault signal is generated by the signal conversion module according to the above-described logical combination of the first overcurrent signal, the first common-mode current signal and the first voltage-to-ground signal, an anode STG fault of the power supply assembly is determined; and
in response to the anode STG fault of the power supply assembly, controlling the controllable power device in parallel connection with the upper bridge arm to be on.

According to an embodiment of the present invention, the bridge arm of the three-phase inverter circuit includes a lower bridge arm; and the controlling the controllable power device to be on when detecting an STG fault includes:
When the second fault signal is generated by the signal conversion module according to the above-described logical combination of the second overcurrent signal, the second common-mode current signal and the second voltage-to-ground signal, a cathode STG fault of the power supply assembly is determined; and
in response to the cathode STG fault of the power supply assembly, controlling the controllable power device in parallel connection with the lower bridge arm to be on.

According to a third aspect, the present invention provides a photovoltaic system, including a power supply assembly and an inverter, where the inverter includes a DC side configured to connect the power supply assembly, and an AC side configured to connect a power grid; and the inverter includes the foregoing protection circuit.

Additional aspects and advantages of the present invention will be partly provided in the following description, and partly become evident in the following description or understood through the practice of the present invention.

### DESCRIPTION OF THE DRAWINGS

The foregoing and/or additional aspects and advantages of the present invention will become apparent and readily understood from the descriptions of the embodiments with reference to the following accompanying drawings, in which:
FIG. 1 is a schematic structural diagram of a photovoltaic system according to an embodiment of the present invention;
FIG. 2 is a schematic structural diagram of a protection circuit according to an embodiment of the present invention;
FIG. 3 is a first structural block diagram of a signal conversion circuit according to an embodiment of the present invention;
FIG. 4 is a second structural block diagram of a signal conversion circuit according to an embodiment of the present invention;
FIG. 5 is a third structural block diagram of a signal conversion circuit according to an embodiment of the present invention;
FIG. 6 is a structural view for disconnecting a relay assembly according to an embodiment of the present invention;
FIG. 7 illustrates a first time sequence for disconnecting a relay assembly of each phase in a three-phase inverter circuit according to an embodiment of the present invention;
FIG. 8 illustrates a second time sequence for disconnecting a relay assembly of each phase in a three-phase inverter circuit according to an embodiment of the present invention;
FIG. 9 illustrates a third time sequence for disconnecting a relay assembly of each phase in a three-phase inverter circuit according to an embodiment of the present invention;
FIG. 10 is a flowchart of a control method according to an embodiment of the present invention;
FIG. 11 illustrates a fourth time sequence for disconnecting a relay assembly of each phase in a three-phase inverter circuit according to an embodiment of the present invention;
FIG. 12 is a schematic structural diagram of a protection circuit applied to a split-phase inverter circuit according to another embodiment of the present invention (not constituting a part of the present invention);
FIG. 13 illustrates a first time sequence for disconnecting a relay assembly of each phase in a split-phase inverter circuit according to another embodiment of the present invention (not constituting a part of the present invention);
FIG. 14 illustrates a second time sequence for disconnecting a relay assembly of each phase in a split-phase inverter circuit according to another embodiment of the present invention (not constituting a part of the present invention);
FIG. 15 illustrates a third time sequence for disconnecting a relay assembly of each phase in a split-phase inverter circuit according to another embodiment of the present invention (not constituting a part of the present invention); and
FIG. 16 illustrates a fourth time sequence for disconnecting a relay assembly of each phase in a split-phase inverter circuit according to another embodiment of the present invention (not constituting a part of the present invention).

### Reference numerals:

100: power supply assembly, 200: voltage booster circuit, 300: three-phase inverter circuit, 410: overcurrent detection module, 420: common-mode current detection module, 430: voltage detection module, 441: signal latch circuit, 442: data filtering unit, 500: current detection circuit, K: relay assembly, K1: first relay, K2: second relay, U1-U4: first to fourth AND gates, U5: OR gate, Q: controllable power device, and L: filter inductor.

### SPECIFIC IMPLEMENTATIONS

The embodiments of the present invention are described below in detail. The embodiments are shown in the drawings. The same or similar numerals represent the same or similar elements or elements having the same or similar functions throughout the specification. The embodiments described below with reference to the drawings are exemplary, and are merely intended to explain the present invention, rather than to limit the present invention.

In the following description, "circuit" means an electrically conductive loop consisting of at least one element or subcircuit connected electrically or electromagnetically. When an element or circuit is referred to as being "coupled" or "connected" to another element or an element/circuit is "coupled" or "connected" between two nodes, it can be directly coupled or connected to another element, or there may be an intermediate element. The connection between elements may be a physical connection, a logical connection, or a combination thereof. Conversely, when an element is referred to as being "directly coupled to" or "directly connected to" another element, it means that there is no intermediate element between the two.

In the description, the terms such as "first" and "second" are used to distinguish similar objects and are not intended to describe a specific order or sequence. It should be understood that numerals used in such a way may be interchanged under appropriate circumstances so that the embodiments of the present invention can be implemented in an order other than those illustrated or described herein, the objects distinguished by "first", "second", and the like are usually of one type, and the number of objects is not limited. For example, one or more first objects may be provided. In addition, "and/or" in the specification and claims indicates at least one of the connected objects, and the character "/" generally indicates an "or" relationship between associated objects.

In addition, the description with reference to the terms "one embodiment", "some embodiments", "exemplary embodiments", "examples", "specific examples", or "some examples" means that specific features, structures, materials, or characteristics described in combination with the embodiments or examples are included in at least one embodiment or example of the present invention. In this specification, the schematic representations of the above terms do not necessarily refer to the same embodiment or example.

The photovoltaic system usually includes a photovoltaic assembly and an inverter. The photovoltaic assembly is a large-area solar panel formed by connecting solar panels in series and encapsulating the solar panels, and can be configured to convert solar energy into a DC. The inverter includes voltage booster circuit 200 and three-phase inverter circuit 300. The voltage booster circuit 200 may be configured to convert an output voltage of the photovoltaic assembly into a higher and more stable voltage. The three-phase inverter circuit 300 is configured to convert the DC of the photovoltaic assembly into an AC, which can be directly merged into a power grid or directly supplied to electrical appliances.

In actual engineering, cables of the photovoltaic system are easily damaged for construction or severe environments to cause the STG of the photovoltaic cables. The photovoltaic cables in the STG will generate a kiloampere-level short-circuit current, which is highly risky to damage components in the circuit.

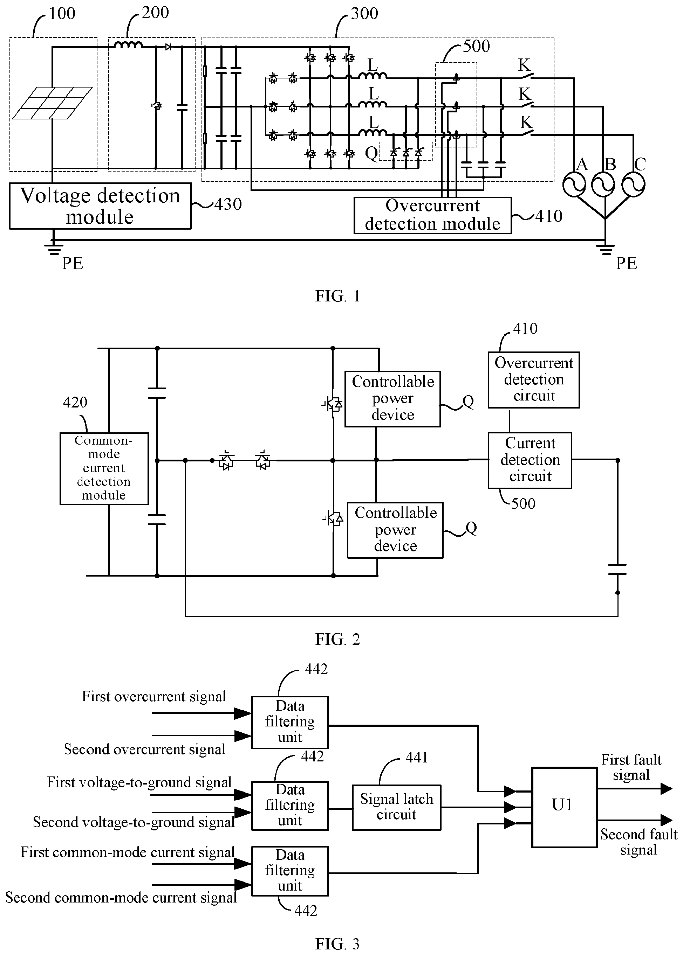

Referring to FIG. 1, The present invention provides a protection circuit. The protection circuit is applied to three-phase inverter circuit 300. A DC side of the three-phase inverter circuit 300 is configured to connect power supply assembly 100. An output terminal of each phase in the three-phase inverter circuit 300 is provided with relay assembly K. The protection circuit includes: controllable power device Q, a fault detection module, current detection circuit 500, and a controller. The controllable power device Q is in parallel connection with a bridge arm in the three-phase inverter circuit 300. The fault detection module is electrically connected to the three-phase inverter circuit 300, and configured to generate a fault signal when detecting an STG fault. The current detection circuit 500 is electrically connected to the three-phase inverter circuit 300, and configured to detect an output current of each phase in the three-phase inverter circuit 300. The controller is electrically connected to the fault detection module, the current detection circuit 500 and the relay assembly K, and configured to control the controllable power device Q to be on after receiving the fault signal, and disconnect the relay assembly K of each phase when the output current of each phase meets a zero-crossing condition.

The power supply assembly 100 may be a photovoltaic assembly. The photovoltaic assembly is configured to transmit electric energy to the three-phase inverter circuit 300 through a photovoltaic cable. The STG fault may occur on a cable connected to an anode of the photovoltaic assembly, and may also occur on a cable connected to a cathode of the photovoltaic assembly.

The bridge arm in the three-phase inverter circuit 300 includes an upper bridge arm and a lower bridge arm. The upper bridge arm and the lower bridge arm each include at least one switching tube. The switching tube may be a metal-oxide-semiconductor field-effect transistor (MOSFET) or an insulated gate bipolar transistor (IGBT). A flyback diode is provided in the switching tube.

The controllable power device Q is in parallel connection with the bridge arm in the three-phase inverter circuit 300. When the circuit works normally, the controllable power device Q is in an off state, without affecting normal operation of the three-phase inverter circuit 300 and generating excessive heat. When the STG fault is detected, the controllable power device Q is turned on to shunt a short-circuit current flowing through the flyback diode in the bridge arm, thereby preventing damage of the short-circuit current on other devices in the circuit.

The controllable power device Q may be a fully-controlled power device, and may also be a half-controlled power device. The specific type of the controllable power device Q may be selected according to an actual application scenario, and is not limited herein. For example, the controllable power device Q may be a thyristor, an MOSFET or an IGBT.

The fault detection module is electrically connected to the three-phase inverter circuit 300. The fault detection module can be configured to monitor an operating state of the three-phase inverter circuit 300 in real time, generate the fault signal when detecting the STG fault, and send the fault signal to the controller.

The current detection circuit 500 is electrically connected to an output terminal of the three-phase inverter circuit 300, and can be configured to detect the output current of each phase in the three-phase inverter circuit 300, and send the detected output current to the controller. The specific structure of the current detection circuit 500 may be selected according to an actual application scenario, and is not limited herein. For example, the current detection circuit 500 may include a current sensor.

The controller is electrically connected to the fault detection module. The controller is configured to control the controllable power device Q to be on after receiving the fault signal. The short-circuit current flowing through the flyback diode in the bridge arm is shunted by the controllable power device Q, thereby preventing damage of the short-circuit current on other devices in the circuit.

The controller is further electrically connected to the current detection circuit 500 and the relay assembly K. After receiving the fault signal, the controller is configured to determine, according to the output current of each phase from the current detection circuit 500, whether the output current of each phase meets the zero-crossing condition. When the output current of each phase meets the zero-crossing condition, the relay assembly K of each phase is disconnected by the controller to realize automatic isolation of the fault.

According to the protection circuit provided by the present invention, in response to an STG fault between the three-phase inverter circuit 300 and the power supply assembly 100, the controller controls the controllable power device Q to be on, such that a short-circuit current flowing through a flyback diode in the lower bridge arm is shunted by the controllable power device Q, thereby preventing damage of the overlarge short-circuit current on the flyback diode in the bridge arm. In addition, when the output current of each phase meets the zero-crossing condition, the relay assembly K of each phase is disconnected by the controller. This not only can disconnect the relay assembly K safely, but also can cut off the loop of the short-circuit current, thereby preventing damage of the short-circuit current on components in the circuit.

Referring to FIG. 2, FIG. 2 is a schematic view of a protection circuit in a single-phase inverter circuit. In some embodiments, the bridge arm includes an upper bridge arm and a lower bridge arm. The fault detection module is configured to generate a first fault signal when detecting an anode STG fault of the power supply assembly 100, and/or generate a second fault signal when detecting a cathode STG fault of the power supply assembly 100.

The controller is configured to control the controllable power device Q in parallel connection with the upper bridge arm to be on when receiving the first fault signal, and/or control the controllable power device Q in parallel connection with the lower bridge arm to be on when receiving the second fault signal.

When the cable connected to the anode of the photovoltaic assembly has the STG fault, a short-circuit current flows through the upper bridge arm. When the cable connected to the cathode of the photovoltaic assembly has the STG fault, a short-circuit current flows through the lower bridge arm.

The fault detection module is configured to transmit the first fault signal to the controller when detecting the anode STG fault of the power supply assembly 100. The controller is configured to control the controllable power device Q in parallel connection with the upper bridge arm to be on. That is, in response to the anode STG fault of the power supply assembly 100, the controllable power device Q in parallel connection with the upper bridge arm is used to shunt the short-circuit current. Specifically, the controllable power device includes silicon controlled rectifiers (SCRs) corresponding to output phases of the three-phase inverter circuit. Each SCR is provided between the anode of the power supply assembly and the upper bridge arm of the phase. When the anode of the power supply assembly is grounded, the controllable power device is started, such that the SCR is turned on to shunt a current from the anode of the power supply assembly to a switching device, wherein the switching device is between the upper bridge arms of the phases at an AC side of the three-phase inverter circuit.

The fault detection module is configured to transmit the second fault signal to the controller when detecting the cathode STG fault of the power supply assembly 100. The controller is configured to control the controllable power device Q in parallel connection with the lower bridge arm to be on. That is, in response to the cathode STG fault of the power supply assembly 100, the controllable power device Q in parallel connection with the lower bridge arm is used to shunt the short-circuit current. Specifically, the controllable power device includes SCRs corresponding to output phases of the inverter circuit. Each SCR is provided between the cathode of the power supply assembly and the lower bridge arm of the phase. When the cathode of the power supply assembly is grounded, the controllable power device is started, such that the SCR is turned on to shunt a current from the cathode of the power supply assembly to a switching device, wherein the switching device is between the lower bridge arms of the phases at the AC side of the three-phase inverter circuit.

The fault detection module includes: overcurrent detection module 410, common-mode current detection module 420, voltage detection module 430, and a signal conversion module. The overcurrent detection module 410 is electrically connected to the current detection circuit 500, and configured to generate a first overcurrent signal when a negative output current of at least one phase is greater than a first current threshold, and/or generate a second overcurrent signal when a positive output current of at least one phase is greater than a second current threshold. The common-mode current detection module 420 is electrically connected to the DC side of the three-phase inverter circuit 300, and configured to generate a first common-mode current signal when a negative common-mode current at the DC side of the three-phase inverter circuit 300 is greater than a third current threshold, and/or generate a second common-mode current signal when a positive common-mode current at the DC side of the three-phase inverter circuit 300 is greater than a fourth current threshold. The voltage detection module 430 is electrically connected to the anode of the power supply assembly 100, the cathode of the power supply assembly 100 and a ground node, and configured to generate a first voltage-to-ground signal when a voltage-to-ground between the anode of the power supply assembly 100 and the ground node is less than a voltage threshold, and/or generate a second voltage-to-ground signal when a voltage-to-ground between the cathode of the power supply assembly 100 and the ground node is less than a second voltage threshold. The signal conversion module is electrically connected to the overcurrent detection module 410, the common-mode current detection module 420 and the voltage detection module 430, and configured to generate the first fault signal and/or the second fault signal according to a logical combination of the signals output by the overcurrent detection module 410, the common-mode current detection module 420 and the voltage detection module 430.

The overcurrent detection module 410 is electrically connected to the current detection circuit 500, and mainly configured to compare a current detected by the current detection circuit 500. The current detection circuit 500 is electrically connected to the output terminal of the three-phase inverter circuit 300, and its detected current is an AC. The overcurrent detection module 410 can be configured to determine the positive output current and the negative output current in the output current.

The overcurrent detection module 410 is configured to generate the first overcurrent signal when the negative output current of at least one phase is greater than the first current threshold. The overcurrent detection module 410 is configured to generate the second overcurrent signal when the positive output current of at least one phase is greater than the second current threshold. The specific value of the first current threshold may be selected according to an actual application scenario, and is not limited herein. For example, the first current threshold may be 13 A, 15 A or 20 A. The absolute value of the specific value of the second current threshold may be the same as the first current threshold.

The specific structure of the overcurrent detection module 410 may be selected according to an actual application scenario, and is not limited herein. For example, the overcurrent detection module 410 may include a comparator. The comparator includes a positive input terminal electrically connected to an output terminal of the current detection circuit 500, and a negative input terminal configured to access the first current threshold.

The common-mode current detection module 420 is provided at an input terminal of the three-phase inverter circuit 300, and may be configured to determine whether the three-phase inverter circuit 300 has an abnormal large current by detecting whether a positive busbar and a negative busbar have a common-mode current. The current on the positive busbar and the current on the negative busbar have opposite directions and a same size normally. Hence, normally, the common-mode current on the positive busbar and the negative busbar is zero. When the common-mode current detection module 420 detects that the negative common-mode current on the positive busbar and the negative busbar is greater than the third current threshold, it is indicated that the cable connected to the anode of the photovoltaic assembly may have the STG fault, and thus the first common-mode current signal is generated. When the common-mode current detection module 420 detects that the positive common-mode current on the positive busbar and the negative busbar is greater than the fourth current threshold, it is indicated that the cable connected to the cathode of the photovoltaic assembly may have the STG fault, and thus the second common-mode current signal is generated.

The specific value of the third current threshold may be selected according to an actual application scenario, and is not limited herein. For example, the first current threshold may be 1A or 2A. The absolute value of the specific value of the fourth current threshold may be the same as the third current threshold.

In response to the cathode STG of the photovoltaic assembly, because of the short-circuit current, a potential difference between the cathode of the photovoltaic assembly and the ground node is reduced quickly. Hence, when the voltage detection module 430 detects that the voltage-to-ground between the cathode and the ground node is less than the voltage threshold, it is indicated that the cable connected to the cathode of the photovoltaic assembly may have the STG fault. Likewise, in response to the anode STG of the photovoltaic assembly, because of the short-circuit current, a potential difference between the anode of the photovoltaic assembly and the ground node is reduced quickly. Hence, when the voltage detection module 430 detects that the voltage-to-ground between the anode and the ground node is less than the voltage threshold, it is indicated that the cable connected to the anode of the photovoltaic assembly may have the STG fault.

The specific value of the first voltage threshold and the specific value of the second voltage threshold may be selected according to an actual application scenario, and are not limited herein. The specific value of the first voltage threshold and the specific value of the second voltage threshold may be the same, and may also be different. For example, the first voltage threshold may be 100 V or 150 V, and the second voltage threshold may be 100 V or 130 V.

When the signal conversion module receives at least one of the first overcurrent signal, the first common-mode current signal and the first voltage-to-ground signal, it is indicated that the cable connected to the anode of the photovoltaic assembly may have the STG fault, and thus the first fault signal is generated. When the signal conversion module receives at least one of the second overcurrent signal, the second common-mode current signal and the second voltage-to-ground signal, it is indicated that the cable connected to the cathode of the photovoltaic assembly may have the STG fault, and thus the second fault signal is generated.

Referring to FIG. 3, the signal conversion module includes a first AND gate. The first AND gate includes an input terminal electrically connected to an output terminal of the overcurrent detection module 410, an output terminal of the common-mode current detection module 420 and an output terminal of the voltage detection module 430, and an output terminal electrically connected to the controller.

When the first AND gate receives the first overcurrent signal, the first common-mode current signal and the first voltage-to-ground signal, it is indicated that the cable connected to the anode of the photovoltaic assembly may have the STG fault, and thus the first fault signal is generated. When the first AND gate receives the second overcurrent signal, the second common-mode current signal and the voltage-to-ground signal, it is indicated that the cable connected to the cathode of the photovoltaic assembly may have the STG fault, and thus the second fault signal is generated.

The first AND gate is used to generate the fault signal. This can ensure accuracy of the fault signal, prevent false triggering due to an interference signal, and improve accuracy of an action of the protection circuit.

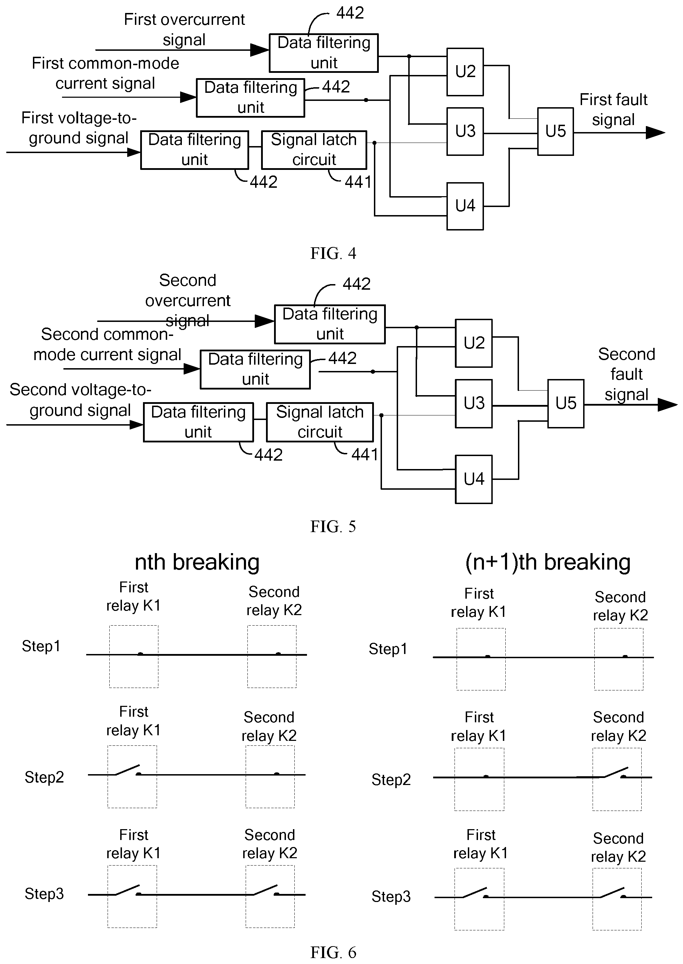

Referring to FIG. 4 and FIG. 5, the signal conversion module includes: a second AND gate, a third AND gate, a fourth AND gate, and an OR gate. The second AND gate includes an input terminal electrically connected to an output terminal of the overcurrent detection module and an output terminal of the common-mode current detection module. The third AND gate includes an input terminal electrically connected to the output terminal of the overcurrent detection module and an output terminal of the voltage detection module. The fourth AND gate includes an input terminal electrically connected to the output terminal of the common-mode current detection module and the output terminal of the voltage detection module. The OR gate includes an input terminal electrically connected to an output terminal of the second AND gate, an output terminal of the third AND gate and an output terminal of the fourth AND gate, and an output terminal electrically connected to the controller.

Referring to FIG. 4, the second AND gate outputs a high level signal when receiving the first overcurrent signal and the first common-mode current signal at the same time. The third AND gate outputs a high level signal when receiving the first overcurrent signal and the first voltage-to-ground signal at the same time. The fourth AND gate outputs a high level signal when receiving the first common-mode current signal and the first voltage-to-ground signal at the same time.

The input terminal of the OR gate is electrically connected to the output terminal of the second AND gate, the output terminal of the third AND gate and the output terminal of the fourth AND gate. That is, the signal conversion module generates the first fault signal when receiving any two of the first overcurrent signal, the first common-mode current signal and the first voltage-to-ground signal.

Referring to FIG. 5, the second AND gate outputs a high level signal when receiving the second overcurrent signal and the second common-mode current signal at the same time. The third AND gate outputs a high level signal when receiving the second overcurrent signal and the second voltage-to-ground signal at the same time. The fourth AND gate outputs a high level signal when receiving the second common-mode current signal and the second voltage-to-ground signal at the same time.

The input terminal of the OR gate is electrically connected to the output terminal of the second AND gate, the output terminal of the third AND gate and the output terminal of the fourth AND gate. That is, the signal conversion module generates the second fault signal when receiving any two of the second overcurrent signal, the second common-mode current signal and the second voltage-to-ground signal.

With a logical combination of the AND gate and the OR gate, the signal conversion module generates the fault signal when any two of the overcurrent detection module, the common-mode current detection module and the voltage detection module generate corresponding signals. This not only can ensure accuracy of the fault signal and prevent false triggering due to the interference signal, but also can omit the determination step to make generation of the fault signal simpler.

Referring also to FIG. 3 to FIG. 5, in some embodiments, the signal conversion module further includes a signal latch circuit. The signal latch circuit is electrically connected to the output terminal of the voltage detection module 430, and mainly configured to maintain, when the voltage detection module 430 generates the first voltage-to-ground signal or the second voltage-to-ground signal, a level of the voltage-to-ground signal, thereby providing time for logical determination of the AND gate.

In some embodiments, the signal conversion module further includes a data filtering unit. The data filtering unit includes an input terminal electrically connected to an output terminal of the overcurrent detection module 410, an output terminal of the common-mode current detection module 420 and an output terminal of the voltage detection module 430, and configured to filter the first overcurrent signal, the second overcurrent signal, the first common-mode current signal, the second common-mode current signal, the first voltage-to-ground signal and/or the second voltage-to-ground signal.

The data filtering unit is mainly configured to eliminate noise and interference in the first overcurrent signal, the second overcurrent signal, the first common-mode current signal, the second common-mode current signal, the first voltage-to-ground signal and the second voltage-to-ground signal. The data filtering unit may be realized in a software filtering manner. The data filtering unit is configured to convert the first overcurrent signal, the second overcurrent signal, the first common-mode current signal, the second common-mode current signal, the first voltage-to-ground signal and the second voltage-to-ground signal generated by the fault detection module into a digital signal through analog-digital conversion. With a filtering algorithm, the data filtering unit has high flexibility and high adjustability.

According to some embodiments, the relay assembly includes a plurality of relays connected in series. The controller is electrically connected to the relays, and configured to use at least two relay disconnecting sequences when disconnecting the relay assembly repeatedly.

Whenever the relay assembly is disconnected, there is a chronological sequence to disconnect the relays. The relay disconnected first suffers wear caused by a small current in the disconnection process. When the relay assembly is disconnected repeatedly, at least two relay disconnecting sequences are used. This can balance the wear of the relay, and prolong the service life of the relay.

As an example, the relay assembly includes first relay K1, second relay K2, and a third relay connected in series. When the relay assembly is disconnected for a first time, the first relay K1, the second relay K2 and the third relay are disconnected sequentially. When the relay assembly is disconnected for a second time, the second relay K2 is disconnected first, and then the first relay K1 and the third relay are disconnected sequentially. When the relay assembly is disconnected for a third time, the third relay is disconnected first, and then the first relay K1 and the second relay K2 are disconnected sequentially.

Referring to FIG. 6, in some embodiments, the relay assembly includes first relay K1 and second relay K2 connected in series. The controller is configured to execute the following operations alternately: The first relay K1 is disconnected prior to the second relay K2. Or, the second relay K2 is disconnected prior to the first relay K1.

The controller disconnects the first relay K1 prior to the second relay K2 when disconnecting the relay assembly for a first time, and disconnects the second relay K2 prior to the first relay K1 when disconnecting the relay assembly for the second time. By repeating the above operations, the wear of the first relay K1 and the second relay K2 can be balanced, and the service life of the first relay K1 and the second relay K2 can be prolonged.

In some embodiments, the controllable power device Q is a fully-controlled power device. An output node of the three-phase inverter circuit 300 is further connected to filter inductor L. A terminal of the filter inductor L away from the output node is electrically connected to an output terminal of the fully-controlled power device.

With higher control accuracy and a faster response speed, the fully-controlled power device can be turned on timely in response to the STG fault to prevent damage of the short-circuit current on other devices.

The filter inductor L is provided between the output node of the three-phase inverter circuit 300 and the output terminal of the fully-controlled power device. This can protect the safety of the power supply and the circuit through a reverse current in response to the STG fault.

In other embodiments, the filter inductor L includes a first terminal electrically connected to the output terminal of the fully-controlled power device, and a second terminal electrically connected to a first terminal of the relay assembly K, and is configured to realize electrical isolation between the three-phase inverter circuit 300 and the power grid.

In some embodiments, the controller includes: a preliminary breaking module and a main breaking module. The preliminary breaking module is configured to enter a preliminary breaking stage after receiving the fault signal, and determine zero-crossing time when the output current of each phase in the three-phase inverter circuit 300 crosses a zero point for a first time. The main breaking module is configured to enter a main breaking stage after the preliminary breaking stage, and disconnect, when each phase meets at least one of the following conditions, the relay assembly K of the corresponding phase: A time difference between present time and the zero-crossing time is less than a threshold. Or, the output current is less than a fifth current threshold.

After receiving the fault signal from the fault detection module, the preliminary breaking module is configured to determine, according to a detection result of the current detection module, the zero-crossing time when the output current of each phase crosses the zero point first. The zero-crossing time is a point when the current changes from a positive direction to a negative direction or from the negative direction to the positive direction.

The main breaking module is configured to disconnect the relay assembly K of the corresponding phase at target time. The target time is a point determined according to the zero-crossing time. A time difference between the point and the zero-crossing time is less than a preset threshold. This ensures that the relay assembly K is disconnected when the current crosses the zero or approaches the zero, so as to reduce the electric arc and the impact of the current on the relay assembly K. The threshold may be selected according to an actual application scenario, and is not limited herein. For example, the threshold may be 0.5 ms.

The main breaking module is configured to disconnect the relay assembly K of the corresponding phase when the output current is less than the fifth current threshold. This can ensure that the relay assembly K is disconnected when the current approaches the zero. The specific value of the fifth current threshold may be selected according to an actual application scenario, and is not limited herein. For example, the fifth current threshold may be 0.5A or 0.8A.

The main breaking module is configured to disconnect the relay assembly K of the corresponding phase at the target time or when the output current is less than the fifth current threshold. This can ensure that the current when the relay assembly is disconnected is relatively small, thereby preventing damage of an impact current on the relay assembly when the relay assembly is disconnected.

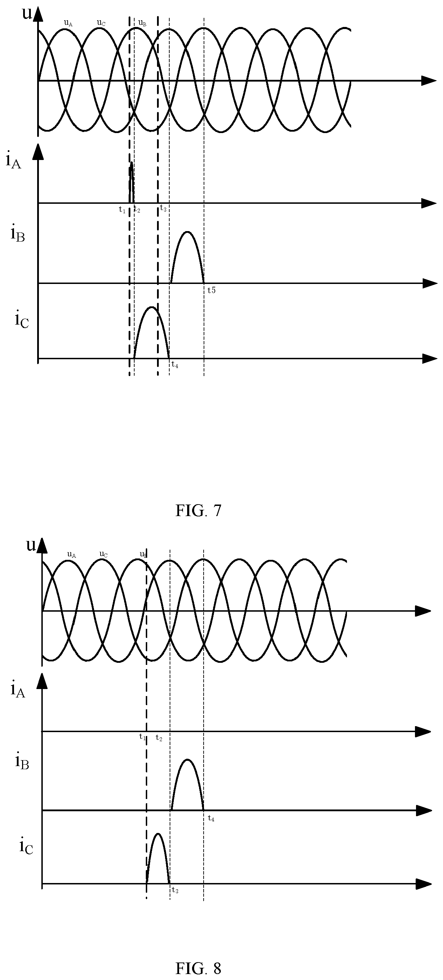

Referring to FIG. 7, as an example, a three-phase inverter includes phase A, phase B, and phase C. At time t1, it is detected that the phase A has the cathode STG fault of the photovoltaic assembly. The preliminary breaking module determines zero-crossing time when an output current of each phase crosses a zero point for a first time, namely zero-crossing time t2 when the phase A crosses the zero point. The main breaking module controls the relay assembly K at an output terminal of the phase A at target time t3. A time difference between the target time t3 and the zero-crossing time t2 is less than the threshold, such that the relay assembly K of each phase A is disconnected when the output current meets the zero-crossing condition. In the figure, the current of the phase C at time t4 is less than the fifth current threshold, such that the relay assembly K of each phase C is disconnected at the time t4. The current of the phase B at time t5 is less than the fifth current threshold, such that the relay assembly K of each phase B is disconnected at the time t4.

In some embodiments, the three-phase inverter circuit uses a three-phase four-wire system. The main breaking module is further configured to enter the main breaking stage after the preliminary breaking stage, and disconnect, when each phase meets at least one of the following conditions, the relay assembly of the corresponding phase: The time difference between the present time and the zero-crossing time is less than the threshold. The output current is less than the fifth current threshold. Or, an angle of a phase voltage falls within a target angle range. In response to the anode STG fault, the target angle range is [180°, 180+θ₁°]. In response to the cathode STG fault, the target angle range is [0°, θ₂°], θ₁ being a first angle threshold, and θ₂ being a second angle threshold.

In response to the anode STG fault, when the angle of the phase voltage falls within [180°, 180+θ₁°], there is no current output from the corresponding phase. By this time, the relay assembly of the corresponding phase is disconnected. This can prevent the damage of the impact current on the relay assembly. Likewise, In response to the cathode STG fault, when the angle of the phase voltage falls within [0°, θ₂°], there is no current output from the corresponding phase. By this time, the relay assembly of the corresponding phase is disconnected. This can prevent the damage of the impact current on the relay assembly.

The θ₁ and the θ₂ may be selected according to an actual application scenario, and is not limited herein. For example, the θ₁ and the θ₂ may be 90°.

The principle that the relay assembly of the corresponding phase is disconnected when the time difference between the present time and the zero-crossing time is less than the threshold or the output current is less than the fifth current threshold may refer to the foregoing embodiment, and is repeated herein.

The main breaking module is configured to disconnect the relay assembly K of the corresponding phase at the target time or when the output current is less than the fifth current threshold, or when the angle of the phase voltage falls within the target angle range. This can ensure that the current when the relay assembly is disconnected is relatively small, thereby preventing the damage of the impact current on the relay assembly when the relay assembly is disconnected.

Referring to FIG. 8, as an example, a three-phase inverter includes phase A, phase B, and phase C. At time t1, it is detected that the phase A has the cathode STG fault of the photovoltaic assembly. The preliminary breaking module determines zero-crossing time when an output current of each phase crosses a zero point for a first time. There comes a main breaking stage at time t2. The angle of the voltage of the phase A at the time t2 meets 0<θ_{A}<θ₂, so the relay assembly K at an output terminal of the phase A is disconnected at the time t2. In the figure, the current of the phase C at time t3 is less than the fifth current threshold, such that the relay assembly K of each phase C is disconnected at the time t3. The current of the phase B at time t4 is less than the fifth current threshold, the relay assembly K of each phase B is disconnected at the time t4.

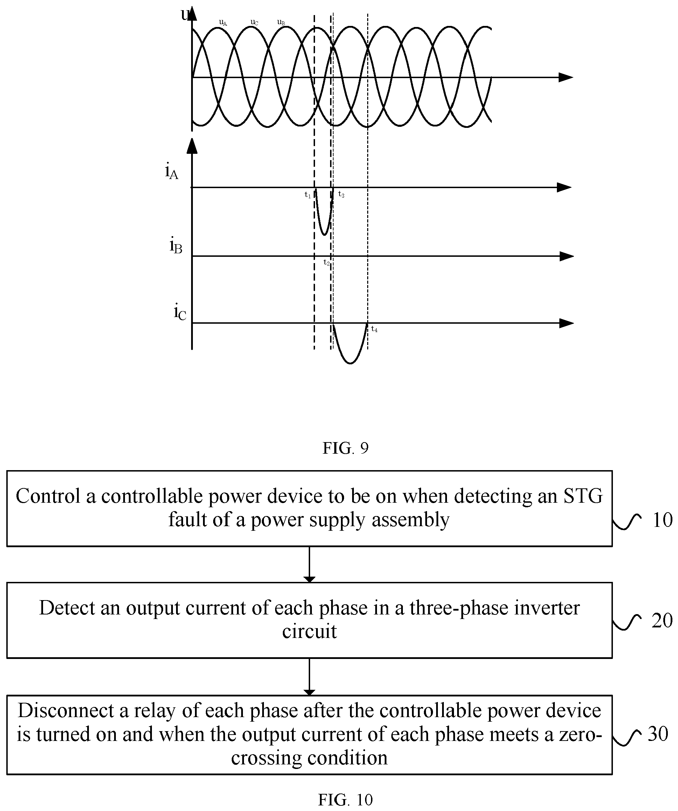

Referring to FIG. 9, in other embodiments, at time t1, it is detected that the phase A has the anode STG fault of the photovoltaic assembly. The preliminary breaking module determines zero-crossing time when an output current of each phase crosses a zero point for a first time.

There comes a main breaking stage at time t2. The angle of the voltage of the phase B at the time t2 meets 0<θ_{B}<180+θ₁°, so the relay assembly K at the output terminal of the phase B is disconnected at the time t2. In the figure, the current of the phase A at time t3 is less than the fifth current threshold, such that the relay assembly K of each phase A is disconnected at the time t3. The current of the phase C at time t4 is less than the fifth current threshold, such that the relay assembly K of each phase C is disconnected at the time t4.

Referring to FIG. 10, The present invention provides a control method. The control method is applied to three-phase inverter circuit 300. A DC side of the three-phase inverter circuit 300 is configured to connect power supply assembly 100. An output terminal of each phase in the three-phase inverter circuit 300 is provided with relay assembly K. A bridge arm in the three-phase inverter circuit 300 is in parallel connection with controllable power device Q. The control method includes: Step 10, Step 20, and Step 30.

Step 10: The controllable power device Q is controlled to be on when an STG fault of the power supply assembly 100 is detected.

Step 20: An output current of each phase in the three-phase inverter circuit 300 is detected.

Step 30: The relay assembly K of each phase is disconnected after the controllable power device Q is turned on and when the output current of each phase meets a zero-crossing condition.

According to the control method provided by the present invention, an executive body of the control method may be the foregoing controller or a functional module or a functional entity capable of realizing the control method in the controller. The control method provided by the present invention is described below with the controller as the executive body.

The power supply assembly 100 may be a photovoltaic assembly. The photovoltaic assembly is configured to transmit electric energy to the three-phase inverter circuit 300 through a photovoltaic cable. The STG fault may occur on a cable connected to an anode of the photovoltaic assembly, and may also occur on a cable connected to a cathode of the photovoltaic assembly.

When the circuit works normally, the controllable power device Q is in an off state, without affecting normal operation of the three-phase inverter circuit 300 and generating excessive heat. In response to the STG fault of the power supply assembly 100, the controller controls the controllable power device Q to be on. The controllable power device Q is configured to shunt a short-circuit current flowing through a flyback diode in the bridge arm, thereby preventing damage of the short-circuit current on other devices in the circuit.

The output current of each phase in the three-phase inverter circuit 300 is monitored by the controller in real time. When the output current of each phase meets the zero-crossing condition, the relay assembly K of each phase is disconnected by the controller to realize automatic isolation of the fault.

The relay assembly K of each phase is disconnected when the output current of each phase meets the zero-crossing condition, which means that the relay assembly K of each phase is disconnected when the output current of the corresponding phase is zero or approaches the zero, thereby realizing safe disconnection of the relay assembly K.

The relay assembly K of each phase is disconnected by the controller when the output current of each phase meets the zero-crossing condition, which can reduce the electric arc and the impact of the current on the relay assembly K, and disconnects the relay assembly K safely. Meanwhile, with the disconnected relay assembly K of each phase, the loop of the short-circuit current can be cut off to prevent damage of the short-circuit current on components in the circuit.

According to the control method provided by the present invention, in response to an STG fault between the three-phase inverter circuit 300 and the power supply assembly 100, the controller controls the controllable power device Q to be on, such that a short-circuit current flowing through a flyback diode in the lower bridge arm is shunted by the controllable power device Q, thereby preventing damage of the overlarge short-circuit current on the flyback diode in the bridge arm. In addition, when the output current of each phase meets the zero-crossing condition, the relay assembly K of each phase is disconnected by the controller. This not only can disconnect the relay assembly K safely, but also can cut off the loop of the short-circuit current, thereby preventing damage of the short-circuit current on components in the circuit.

In some embodiments, that the relay assembly K of each phase is disconnected when the output current of each phase meets a zero-crossing condition includes: In a first stage, zero-crossing time when the output current of each phase in the three-phase inverter circuit crosses a zero point for a first time is determined. In a second stage, the relay assembly of the corresponding phase is disconnected when each phase meets at least one of the following conditions: A time difference between present time and the zero-crossing time is less than a threshold. Or, the output current is less than a fifth current threshold.

In the first stage, the controller determines the zero-crossing time when the output current of each phase in the three-phase inverter circuit 300 crosses the zero point first and records the zero-crossing time. The zero-crossing point is a point when the current changes from a positive direction to a negative direction or from the negative direction to the positive direction.

In the second stage, the relay assembly K of the corresponding phase is disconnected at target time or when the output current is less than the fifth current threshold. This can ensure that the current when the relay assembly is disconnected is relatively small, thereby preventing damage of an impact current on the relay assembly when the relay assembly is disconnected.

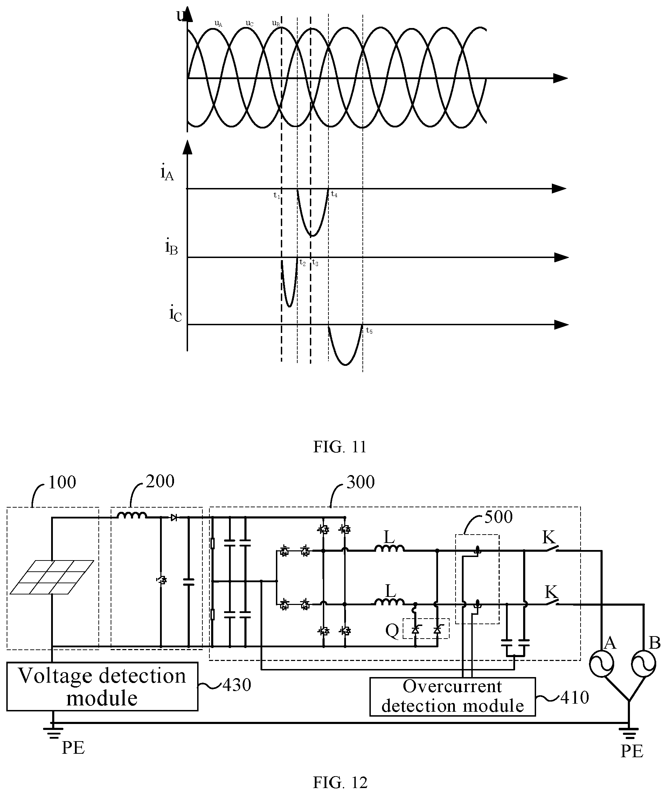

Referring to FIG. 11, as an example, a three-phase inverter includes phase A, phase B, and phase C. At time t1, it is detected that the phase A has the anode STG fault of the photovoltaic assembly. The preliminary breaking module determines zero-crossing time when an output current of each phase crosses a zero point for a first time, namely zero-crossing time t2 when the phase B crosses the zero point. The main breaking module controls the relay assembly K at an output terminal of the phase B at target time t3. A time difference between the target time t3 and the zero-crossing time t2 is less than the threshold, such that the relay assembly K of each phase B is disconnected when the output current meets the zero-crossing condition. In the figure, the current of the phase A at time t4 is less than the fifth current threshold, such that the relay assembly K of each phase A is disconnected at the time t4. The current of the phase C at time t5 is less than the fifth current threshold, such that the relay assembly K of each phase C is disconnected at the time t5.

In some embodiments, the three-phase inverter circuit uses a three-phase four-wire system. The control method further includes: An angle of each phase voltage is acquired. In the second stage, the relay assembly of the corresponding phase is disconnected when each phase meets at least one of the following conditions: The time difference between the present time and the zero-crossing time is less than the threshold. The output current is less than the fifth current threshold. Or, the angle of the phase voltage falls within a target angle range. In response to an anode STG fault, the target angle range is [180°, 180+θ₁°]. In response to a cathode STG fault, the target angle range is [0°, θ₂°], θ₁ being a first angle threshold, and θ₂ being a second angle threshold.

In response to the anode STG fault, when the angle of the phase voltage falls within [180°, 180+θ₁°], there is no current output from the corresponding phase. By this time, the relay assembly of the corresponding phase is disconnected. This can prevent the damage of the impact current on the relay assembly. Likewise, In response to the cathode STG fault, when the angle of the phase voltage falls within [0°, θ₂°], there is no current output from the corresponding phase. By this time, the relay assembly of the corresponding phase is disconnected. This can prevent the damage of the impact current on the relay assembly.

In the second stage, the relay assembly K of the corresponding phase is disconnected at the target time or when the output current is less than the fifth current threshold, or when the angle of the phase voltage falls within the target angle range. This can ensure that the current when the relay assembly is disconnected is relatively small, thereby preventing the damage of the impact current on the relay assembly when the relay assembly is disconnected.

In some embodiments, the bridge arm of the three-phase inverter circuit 300 includes an upper bridge arm. That the controllable power device Q is controlled to be on when an STG fault is detected includes: When it is detected that a negative output current of at least one phase in the three-phase inverter circuit 300 is greater than a first current threshold, and/or a negative common-mode current at the DC side of the three-phase inverter circuit 300 is greater than a third current threshold, and/or a voltage-to-ground between an anode of the power supply assembly and a ground node is less than a first voltage threshold, the anode STG fault of the power supply assembly 100 is determined. In response to the anode STG fault of the power supply assembly 100, the controllable power device Q in parallel connection with the upper bridge arm is controlled to be on.

When the negative output current of at least one phase in the three-phase inverter circuit 300 is greater than the first current threshold, or the negative common-mode current on the positive busbar and the negative busbar is greater than the third current threshold, or the voltage-to-ground between the anode of the power supply assembly and the ground node is less than the first voltage threshold, or the above three cases occur at the same time, it is indicated that when the cable connected to the anode of the photovoltaic assembly has the STG fault, and the short-circuit current flows through the upper bridge arm. The specific principle can refer to the above embodiment, and is not repeated herein.

When the cable connected to the anode of the photovoltaic assembly has the STG fault, the controllable power device Q in parallel connection with the upper bridge arm is controlled to be on. This can shunt a short-circuit current flowing through the upper bridge arm, thereby preventing damage of the short-circuit current on other devices.

In some embodiments, the bridge arm of the three-phase inverter circuit 300 includes a lower bridge arm. That the controllable power device Q is controlled to be on when an STG fault is detected includes: When it is detected that a positive output current of at least one phase in the three-phase inverter circuit 300 is greater than a second current threshold, and/or a positive common-mode current at the DC side of the three-phase inverter circuit 300 is greater than a fourth current threshold, and/or a voltage-to-ground between a cathode of the power supply assembly 100 and a ground node is less than a second voltage threshold, a cathode STG fault of the power supply assembly 100 is determined. In response to the cathode STG fault of the power supply assembly 100, the controllable power device Q in parallel connection with the lower bridge arm is controlled to be on.

When at least one of a case where the positive output current of at least one phase in the three-phase inverter circuit 300 is greater than the second current threshold, or the positive common-mode current at the DC side of the three-phase inverter circuit 300 is greater than the fourth current threshold, or the voltage-to-ground between the cathode of the power supply assembly 100 and the ground node is less than the voltage threshold occur, it is indicated that when the cable connected to the cathode of the photovoltaic assembly has the STG fault, and the short-circuit current flows through the lower bridge arm. The specific principle can refer to the above embodiment, and is not repeated herein.

When the cable connected to the cathode of the photovoltaic assembly has the STG fault, the controllable power device Q in parallel connection with the lower bridge arm is controlled to be on. This can shunt a short-circuit current flowing through the lower bridge arm, thereby preventing damage of the short-circuit current on other devices.

In some embodiments, the relay assembly includes a plurality of relays connected in series. The control method further includes: At least two relay disconnecting sequences are used when the relay assembly is disconnected repeatedly.

Whenever the relay assembly is disconnected, there is a chronological sequence to disconnect the relays. The relay disconnected first suffers wear caused by a small current in the disconnection process. When the relay assembly is disconnected repeatedly, at least two relay disconnecting sequences are used. This can balance the wear of the relay, and prolong the service life of the relay.

In some embodiments, the relay assembly includes first relay K1 and second relay K2 connected in series. The control method further includes: The following operations are executed alternately: The first relay K1 is disconnected prior to the second relay K2. Or, the second relay K2 is disconnected prior to the first relay K1.

The controller disconnects the first relay K1 prior to the second relay K2 when disconnecting the relay assembly for a first time, and disconnects the second relay K2 prior to the first relay K1 when disconnecting the relay assembly for a second time. Or, the controller disconnects the second relay K2 prior to the first relay K1 when disconnecting the relay assembly for a first time, and disconnects the first relay K1 prior to the second relay K2 when disconnecting the relay assembly for a second time. By repeating the above operations, the wear of the first relay K1 and the second relay K2 can be balanced, and the service life of the first relay K1 and the second relay K2 can be prolonged.

The present invention provides a photovoltaic system. The photovoltaic system includes power supply assembly 100 and an inverter. The inverter includes a DC side configured to connect the power supply assembly 100, and an AC side configured to connect a power grid. The inverter includes the foregoing protection circuit, or a controller for realizing the foregoing control method.

The inverter includes three-phase inverter circuit 300 and the foregoing protection circuit. The three-phase inverter circuit 300 includes a DC side configured to connect the power supply assembly 100, and an AC side configured to connect the power grid. The protection circuit is electrically connected to the three-phase inverter circuit 300. The controller is configured to connect controllable power device Q in the protection circuit in response to an STG fault between the three-phase inverter circuit 300 and the power supply assembly 100, and disconnect, when an output current of each phase meets a zero-crossing condition, a relay assembly K of each phase.

The specific structure and function of the protection circuit may refer to the foregoing embodiment, and are not repeated herein.

According to the photovoltaic system provided by the present invention, in response to an STG fault between the three-phase inverter circuit 300 and the power supply assembly 100, the controller controls the controllable power device Q to be on, such that a short-circuit current flowing through a flyback diode in the lower bridge arm is shunted by the controllable power device Q, thereby preventing damage of the overlarge short-circuit current on the flyback diode in the bridge arm. In addition, when the output current of each phase meets the zero-crossing condition, the relay assembly K of each phase is disconnected by the controller. This not only can disconnect the relay assembly K safely, but also can cut off the loop of the short-circuit current, thereby preventing damage of the short-circuit current on components in the circuit.

Referring to FIG. 12, another embodiment not forming part of the claimed invention provides a protection circuit applied to a split-phase inverter circuit. The protection circuit is similar to the protection circuit applied to the three-phase inverter circuit in terms of the overall architecture, except that the three phases are changed into two phases. The bridge arm, the filter inductor L, and the relay assembly are designed in two phases, while the overcurrent detection module and the voltage detection module are the same. The specific structure of the protection circuit still includes the controllable power device Q, the fault detection module, the current detection circuit, and the controller. The controllable power device Q is in parallel connection with the bridge arm in the three-phase inverter circuit 300. SCRs in the controllable power device Q correspond to output phases of the split-phase inverter circuit.

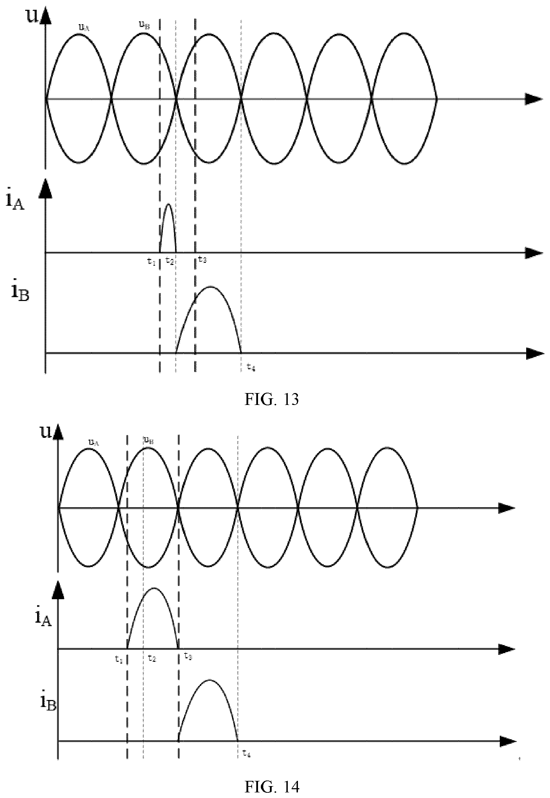

Referring to FIG. 13, as an example not forming part of the claimed invention, a split-phase inverter includes phase A and phase B. At time t1, it is detected that the phase A has the cathode STG fault of the photovoltaic assembly. The preliminary breaking module determines zero-crossing time when an output current of each phase crosses a zero point for a first time, namely zero-crossing time t2 when the phase A crosses the zero point. There comes a main breaking stage at time t3. The main breaking module disconnects the relay assembly K at an output terminal of the phase A at the target time t3. A time difference between the target time t3 and the zero-crossing time t2 is less than the threshold, such that the relay assembly K of each phase A is disconnected when the output current meets the zero-crossing condition. In the figure, the current of the phase B at time t4 is less than the fifth current threshold, namely crosses the zero point naturally, such that the relay assembly K of each phase B is disconnected at the time t4.

Referring to FIG. 14, as an example not forming part of the claimed invention, a split-phase inverter includes phase A and phase B. At time t1, it is detected that the phase A has the cathode STG fault of the photovoltaic assembly. The preliminary breaking module determines zero-crossing time when an output current of each phase crosses a zero point for a first time, namely zero-crossing time t3 when the phase A crosses the zero point. There comes a main breaking stage at time t2. The main breaking module disconnects the relay assembly K at an output terminal of the phase A at zero-crossing time t3 when the phase A crosses the zero point. In the figure, the current of the phase B at time t4 is less than the fifth current threshold, namely crosses the zero point naturally, such that the relay assembly K of each phase B is disconnected at the time t4.

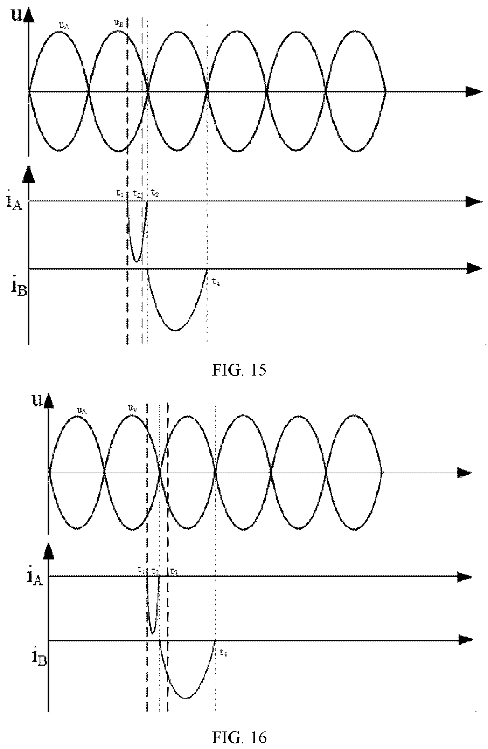

Referring to FIG. 15, as an example not forming part of the claimed invention, a split-phase inverter includes phase A and phase B. At time t1, it is detected that the phase A has the anode STG fault of the photovoltaic assembly. The preliminary breaking module determines zero-crossing time when an output current of each phase crosses a zero point for a first time, namely zero-crossing time t3 when the phase A crosses the zero point. There comes a main breaking stage at time t2. The main breaking module disconnects the relay assembly K at an output terminal of the phase A at zero-crossing time t3 when the phase A crosses the zero point. In the figure, the current of the phase B at time t4 is less than the fifth current threshold, namely crosses the zero point naturally, such that the relay assembly K of each phase B is disconnected at the time t4.

Referring to FIG. 16, as an example not forming part of the claimed invention, a split-phase inverter includes phase A and phase B. At time t1, it is detected that the phase A has the anode STG fault of the photovoltaic assembly. The preliminary breaking module determines zero-crossing time when an output current of each phase crosses a zero point for a first time, namely zero-crossing time t2 when the phase A crosses the zero point. There comes a main breaking stage at time t3. The main breaking module disconnects the relay assembly K at an output terminal of the phase A at the target time t3. A time difference between the target time t3 and the zero-crossing time t2 is less than the threshold, such that the relay assembly K of each phase A is disconnected when the output current meets the zero-crossing condition. In the figure, the current of the phase B at time t4 is less than the fifth current threshold, namely crosses the zero point naturally, such that the relay assembly K of each phase B is disconnected at the time t4.

## Claims

1. A protection circuit, wherein the protection circuit is applied to a three-phase inverter circuit (300); a direct current (DC) side of the three-phase inverter circuit (300) is configured to connect a power supply assembly (100); an output terminal of each phase in the three-phase inverter circuit (300) is provided with a relay assembly (K); and the protection circuit comprises:
a controllable power device (Q) in parallel connection with a bridge arm in the three-phase inverter circuit (300);
a fault detection module electrically connected to the three-phase inverter circuit (300), and configured to generate a first fault signal when detecting an anode short-to-ground, STG, fault of the power supply assembly (100), and/or generate a second fault signal when detecting a cathode STG fault of the power supply assembly (100);
a current detection circuit (500) electrically connected to the three-phase inverter circuit (300), and configured to detect an output current of each phase in the three-phase inverter circuit (300); and
a controller electrically connected to the fault detection module, the current detection circuit (500) and the relay assembly (K), and configured to control the controllable power device (Q) to be on after receiving the first fault signal and/or the second fault signal and disconnect the relay assembly (K) of each phase when the output current of each phase meets a zero-crossing condition;
wherein the fault detection module comprises: an overcurrent detection module (410) electrically connected to the current detection circuit (500), and configured to generate a first overcurrent signal at an output terminal of the overcurrent detection module (410) when a negative output current of at least one phase is greater than a first current threshold, and/or generate a second overcurrent signal at the output terminal of the overcurrent detection module (410) when a positive output current of at least one phase is greater than a second current threshold; a common-mode current detection module (420) electrically connected to the DC side of the three-phase inverter circuit (300), and configured to generate a first common-mode current signal at an output terminal of the common-mode current detection module (420) when a negative common-mode current at the DC side of the three-phase inverter circuit (300) is greater than a third current threshold, and/or generate a second common-mode current signal at the output terminal of the common-mode current detection module (420) when a positive common-mode current at the DC side of the three-phase inverter circuit (300) is greater than a fourth current threshold;
**characterized in that**:
the fault detection module further comprises a voltage detection module (430) electrically connected to an anode of the power supply assembly (100), a cathode of the power supply assembly (100) and a ground node, and configured to generate a first voltage-to-ground signal at an output terminal of the voltage detection module (430) when a voltage-to-ground between the anode of the power supply assembly (100) and the ground node is less than a first voltage threshold, and/or generate a second voltage-to-ground signal at the output terminal of the voltage detection module (430) when a voltage-to-ground between the cathode of the power supply assembly (100) and the ground node is less than a second voltage threshold; and a signal conversion module electrically connected to the overcurrent detection module (410), the common-mode current detection module (420) and the voltage detection module (430);
wherein the signal conversion module comprises: a first AND gate (U1), wherein input terminals of the first AND gate (U1) are respectively and electrically connected to the output terminal of the overcurrent detection module (410), the output terminal of the common-mode current detection module (420) and the output terminal of the voltage detection module (430), and an output terminal of the first AND gate (U1) is electrically connected to the controller, such that, when three of the first overcurrent signal, the first common-mode current signal, and the first voltage-to-ground signal are present at the input terminals of the first AND gate (U1), the first AND gate (U1) is configured to generate the first fault signal at the output terminal of the first AND gate (U1); and when three of the second overcurrent signal, the second common-mode current signal, and the second voltage-to-ground signal are present at the input terminals of the first AND gate (U1), the first AND gate (U1) is configured to generate the second fault signal at the output terminal of the first AND gate (U1); or, the signal conversion module comprises: a second AND gate (U2), wherein input terminals of the second AND gate (U2) are respectively and electrically connected to the output terminal of the overcurrent detection module (410) and the output terminal of the common-mode current detection module (420); a third AND gate (U3), wherein input terminals of the third AND gate (U3) are respectively and electrically connected to the output terminal of the overcurrent detection module (410) and the output terminal of the voltage detection module (430); a fourth AND gate (U4), wherein input terminals of the fourth AND gate (U4) are respectively and electrically connected to the output terminal of the common-mode current detection module (420) and the output terminal of the voltage detection module (430); and an OR gate (U5), wherein input terminals of the OR gate (U5) are respectively and electrically connected to an output terminal of the second AND gate (U2), an output terminal of the third AND gate (U3) and an output terminal of the fourth AND gate (U4), and an output terminal of the OR gate (U5) is electrically connected to the controller, such that when any two of the first overcurrent signal, the first common-mode current signal, and the first voltage-to-ground signal are present at the input terminals of at least one of the second AND gate (U2), the third AND gate (U3), and the fourth AND gate (U4), the OR gate (U5) is configured to generate the first fault signal at the output terminal of the OR gate (U5); and when any two of the second overcurrent signal, the second common-mode current signal, and the second voltage-to-ground signal are present at the input terminals of at least one of the second AND gate (U2), the third AND gate (U3), and the fourth AND gate (U4), the OR gate (U5) is configured to generate the second fault signal at the output terminal of the OR gate (U5).

2. The protection circuit according to claim 1, wherein the bridge arm comprises an upper bridge arm and a lower bridge arm; and
the controller is configured to control the controllable power device (Q) in parallel connection with the upper bridge arm to be on when receiving the first fault signal, and/or control the controllable power device (Q) in parallel connection with the lower bridge arm to be on when receiving the second fault signal.

3. The protection circuit according to claim 1, wherein the signal conversion module further comprises:
a data filtering unit (442), wherein an input terminal of the data filtering unit (442) is electrically connected to an output terminal of the overcurrent detection module (410), an output terminal of the common-mode current detection module (420) and an output terminal of the voltage detection module (430), and the data filtering unit (442) is configured to filter the first overcurrent signal, the second overcurrent signal, the first common-mode current signal, the second common-mode current signal, the first voltage-to-ground signal and/or the second voltage-to-ground signal.

4. The protection circuit according to any one of claims 1 to 3, wherein the relay assembly (K) comprises a plurality of relays connected in series; and the controller is electrically connected to the relays, and configured to use at least two relay disconnecting sequences when disconnecting the relay assembly (K) repeatedly; and
the relay assembly (K) comprises a first relay (K1) and a second relay (K2) connected in series; and the controller is configured to execute the following operations alternately: disconnecting the first relay (K1) prior to the second relay (K2); or, disconnecting the second relay (K2) prior to the first relay (K1).

5. The protection circuit according to any one of claims 1 to 3, wherein the controllable power device (Q) comprises silicon controlled rectifiers (SCRs) corresponding to output phases of the three-phase inverter circuit (300);
each SCR is provided between the anode of the power supply assembly (100) and the bridge arm of each phase; and when the anode of the power supply assembly (100) is grounded, the controllable power device(Q) is started, and the SCR is turned on to shunt a current from the anode of the power supply assembly (100) to a switching device, wherein the switching device is between the bridge arms of the phases at an alternating current (AC) side of the three-phase inverter circuit (300); or
each SCR is provided between the cathode of the power supply assembly (100) and the bridge arm of each phase; and when the cathode of the power supply assembly (100) is grounded, the controllable power device (Q) is started, and the SCR is turned on to shunt a current from the cathode of the power supply assembly (100) to a switching device, wherein the switching device is between the bridge arms of the phases at the AC side of the three-phase inverter circuit (300).

6. The protection circuit according to any one of claims 1 to 3, wherein the controller comprises:
a preliminary breaking module, configured to enter a preliminary breaking stage after receiving the fault signal, and determine zero-crossing time when the output current of each phase in the three-phase inverter circuit (300) crosses a zero point for a first time; and
a main breaking module, configured to enter a main breaking stage after the preliminary breaking stage, and disconnect the relay assembly (K) of a corresponding phase when each phase meets at least one of the following conditions:
a time difference between present time and the zero-crossing time is less than a threshold; or,
the output current is less than a fifth current threshold.

7. The protection circuit according to claim 6, wherein the three-phase inverter circuit (300) uses a three-phase four-wire system; and the main breaking module is further configured to enter the main breaking stage after the preliminary breaking stage, and disconnect the relay assembly (K) of the corresponding phase when each phase meets at least one of the following conditions:
the time difference between the present time and the zero-crossing time is less than the threshold;
the output current is less than the fifth current threshold; or,
an angle of a phase voltage falls within a target angle range, wherein
when the anode STG fault occurs, the target angle range is [180°, 180+θ₁°]; and when the cathode STG fault occurs, the target angle range is [0°, θ₂°], θ₁ being a first angle threshold, and θ₂ being a second angle threshold.

8. A control method for operating a protection circuit according to any one of claims 1-7, wherein the control method is applied to a three-phase inverter circuit (300); a direct current (DC) side of the three-phase inverter circuit (300) is configured to connect a power supply assembly (100); an output terminal of each phase in the three-phase inverter circuit (300) is provided with a relay assembly (K); a bridge arm in the three-phase inverter circuit (300) is in parallel connection with a controllable power device (Q); and the control method comprises:
Step 10: controlling the controllable power device (Q) to be on when a short-to-ground (STG) fault of the power supply assembly (100) is detected;
Step 20: detecting an output current of each phase in the three-phase inverter circuit (300); and
Step 30: disconnecting the relay assembly (K) of each phase after the controllable power device (Q) is turned on and when the output current of each phase meets a zero-crossing condition.

9. The control method according to claim 8, wherein the disconnecting the relay assembly (K) of each phase when the output current of each phase meets a zero-crossing condition comprises:
in a first stage, determining zero-crossing time when the output current of each phase in the three-phase inverter circuit (300) crosses a zero point for a first time; and
in a second stage, disconnecting the relay assembly (K) of a corresponding phase, when each phase meets at least one of the following conditions:
a time difference between present time and the zero-crossing time is less than a threshold; or,
the output current is less than a fifth current threshold.

10. The control method according to claim 9, wherein the three-phase inverter circuit (300) uses a three-phase four-wire system, and the control method further comprises:
acquiring an angle of each phase voltage; and
in the second stage, disconnecting the relay assembly (K) of the corresponding phase, when each phase meets at least one of the following conditions:
the time difference between the present time and the zero-crossing time is less than the threshold;
the output current is less than the fifth current threshold; or,
the angle of the phase voltage falls within a target angle range, wherein
when an anode STG fault occurs, the target angle range is [180°, 180+θ°]; and when a cathode STG fault occurs, the target angle range is [0°, θ₂°], θ₁ being a first angle threshold, and θ₂ being a second angle threshold.

11. The control method according to claim 8, wherein the bridge arm of the three-phase inverter circuit (300) comprises an upper bridge arm; and the controlling the controllable power device (Q) to be on when detecting the STG fault comprises: when the first fault signal is generated according to the signal conversion module, determining an anode STG fault of the power supply assembly (100); and in response to the anode STG fault of the power supply assembly (100) , controlling the controllable power device (Q) in parallel connection with the upper bridge arm to be on.

12. The control method according to claim 8, wherein the bridge arm of the three-phase inverter circuit (300) comprises a lower bridge arm; and the controlling the controllable power device (Q) to be on when detecting the STG fault comprises: when the second fault signal is generated according to the signal conversion module, determining a cathode STG fault of the power supply assembly (100); and in response to the cathode STG fault of the power supply assembly (100) , controlling the controllable power device (Q) in parallel connection with the lower bridge arm to be on.

13. A photovoltaic system, comprising a power supply assembly (100) and an inverter, wherein the inverter comprises a direct current (DC) side configured to connect the power supply assembly (100), and an alternating current (AC) side configured to connect a power grid; and the inverter comprises the protection circuit according to any one of claims 1 to 7.

## Patentansprüche

1. Eine Schutzschaltung, wobei die Schutzschaltung auf eine Dreiphasen-Wechselrichterschaltung (300) angewendet wird; eine Gleichstrom-(DC)-Seite der Dreiphasen-Wechselrichterschaltung (300) dazu konfiguriert ist, eine Stromversorgungsbaugruppe (100) anzuschließen; ein Ausgangsanschluss jeder Phase in der Dreiphasen-Wechselrichterschaltung (300) mit einer Relaisbaugruppe (K) versehen ist; und die Schutzschaltung umfasst:
eine steuerbare Leistungsvorrichtung (Q) in Parallelschaltung mit einem Brückenarm in der Dreiphasen-Wechselrichterschaltung (300);
ein Fehlererkennungsmodul, das elektrisch mit der Dreiphasen-Wechselrichterschaltung (300) verbunden und dazu konfiguriert ist, ein erstes Fehlersignal zu erzeugen, wenn ein Anoden-Kurzschluss-gegen-Masse-, STG-, Fehler der Stromversorgungsbaugruppe (100) erkannt wird, und/oder ein zweites Fehlersignal zu erzeugen, wenn ein Kathoden-STG-Fehler der Stromversorgungsbaugruppe (100) erkannt wird;
eine Stromerkennungsschaltung (500), die elektrisch mit der Dreiphasen-Wechselrichterschaltung (300) verbunden und dazu konfiguriert ist, einen Ausgangsstrom jeder Phase in der Dreiphasen-Wechselrichterschaltung (300) zu erkennen; und
eine Steuerung, die elektrisch mit dem Fehlererkennungsmodul, der Stromerkennungsschaltung (500) und der Relaisbaugruppe (K) verbunden ist,
und dazu konfiguriert ist, die steuerbare Leistungsvorrichtung (Q) nach Empfangen des ersten Fehlersignals und/oder des zweiten Fehlersignals so zu steuern, dass sie eingeschaltet ist, und die Relaisbaugruppe (K) jeder Phase zu trennen, wenn der Ausgangsstrom jeder Phase eine Nulldurchgangsbedingung erfüllt;
wobei das Fehlererkennungsmodul umfasst: ein Überstromerkennungsmodul (410), das elektrisch mit der Stromerkennungsschaltung (500) verbunden und dazu konfiguriert ist, ein erstes Überstromsignal an einem Ausgangsanschluss des Überstromerkennungsmoduls (410) zu erzeugen, wenn ein negativer Ausgangsstrom mindestens einer Phase größer als ein erster Stromschwellenwert ist, und/oder ein zweites Überstromsignal an dem Ausgangsanschluss des Überstromerkennungsmoduls (410) zu erzeugen, wenn ein positiver Ausgangsstrom mindestens einer Phase größer als ein zweiter Stromschwellenwert ist; ein Gleichtaktstromerkennungsmodul (420), das elektrisch mit der DC-Seite der Dreiphasen-Wechselrichterschaltung (300) verbunden und dazu konfiguriert ist, ein erstes Gleichtaktstromsignal an einem Ausgangsanschluss des Gleichtaktstromerkennungsmoduls (420) zu erzeugen, wenn ein negativer Gleichtaktstrom an der DC-Seite der Dreiphasen-Wechselrichterschaltung (300) größer als ein dritter Stromschwellenwert ist, und/oder ein zweites Gleichtaktstromsignal an dem Ausgangsanschluss des Gleichtaktstromerkennungsmoduls (420) zu erzeugen, wenn ein positiver Gleichtaktstrom an der DC-Seite der Dreiphasen-Wechselrichterschaltung (300) größer als ein vierter Stromschwellenwert ist;
**dadurch gekennzeichnet, dass**:
das Fehlererkennungsmodul ferner ein Spannungserkennungsmodul (430), das elektrisch mit einer Anode der Stromversorgungsbaugruppe (100), einer Kathode der Stromversorgungsbaugruppe (100) und einem Masseknoten verbunden und dazu konfiguriert ist, ein erstes Spannung-gegen-Masse-Signal an einem Ausgangsanschluss des Spannungserkennungsmoduls (430) zu erzeugen, wenn eine Spannung gegen Masse zwischen der Anode der Stromversorgungsbaugruppe (100) und dem Masseknoten kleiner als ein erster Spannungsschwellenwert ist, und/oder ein zweites Spannung-gegen-Masse-Signal an dem Ausgangsanschluss des Spannungserkennungsmoduls (430) zu erzeugen, wenn eine Spannung gegen Masse zwischen der Kathode der Stromversorgungsbaugruppe (100) und dem Masseknoten kleiner als ein zweiter Spannungsschwellenwert ist; und ein Signalumwandlungsmodul umfasst, das elektrisch mit dem Überstromerkennungsmodul (410), dem Gleichtaktstromerkennungsmodul (420) und dem Spannungserkennungsmodul (430) verbunden ist;
wobei das Signalumwandlungsmodul umfasst: ein erstes UND-Gatter (U1), wobei Eingangsanschlüsse des ersten UND-Gatters (U1) jeweils elektrisch mit dem Ausgangsanschluss des Überstromerkennungsmoduls (410), dem Ausgangsanschluss des Gleichtaktstromerkennungsmoduls (420) und dem Ausgangsanschluss des Spannungserkennungsmoduls (430) verbunden sind und ein Ausgangsanschluss des ersten UND-Gatters (U1) elektrisch mit der Steuerung verbunden ist, sodass, wenn drei von dem ersten Überstromsignal, dem ersten Gleichtaktstromsignal und dem ersten Spannung-gegen-Masse-Signal an den Eingangsanschlüssen des ersten UND-Gatters (U1) vorhanden sind, das erste UND-Gatter (U1) dazu konfiguriert ist, das erste Fehlersignal an dem Ausgangsanschluss des ersten UND-Gatters (U1) zu erzeugen; und wenn drei von dem zweiten Überstromsignal, dem zweiten Gleichtaktstromsignal und dem zweiten Spannung-gegen-Masse-Signal an den Eingangsanschlüssen des ersten UND-Gatters (U1) vorhanden sind, das erste UND-Gatter (U1) dazu konfiguriert ist, das zweite Fehlersignal an dem Ausgangsanschluss des ersten UND-Gatters (U1) zu erzeugen; oder das Signalumwandlungsmodul umfasst: ein zweites UND-Gatter (U2), wobei Eingangsanschlüsse des zweiten UND-Gatters (U2) jeweils elektrisch mit dem Ausgangsanschluss des Überstromerkennungsmoduls (410) und dem Ausgangsanschluss des Gleichtaktstromerkennungsmoduls (420) verbunden sind; ein drittes UND-Gatter (U3), wobei Eingangsanschlüsse des dritten UND-Gatters (U3) jeweils elektrisch mit dem Ausgangsanschluss des Überstromerkennungsmoduls (410) und dem Ausgangsanschluss des Spannungserkennungsmoduls (430) verbunden sind; ein viertes UND-Gatter (U4), wobei Eingangsanschlüsse des vierten UND-Gatters (U4) jeweils elektrisch mit dem Ausgangsanschluss des Gleichtaktstromerkennungsmoduls (420) und dem Ausgangsanschluss des Spannungserkennungsmoduls (430) verbunden sind; und ein ODER-Gatter (U5), wobei Eingangsanschlüsse des ODER-Gatters (U5) jeweils elektrisch mit einem Ausgangsanschluss des zweiten UND-Gatters (U2), einem Ausgangsanschluss des dritten UND-Gatters (U3) und einem Ausgangsanschluss des vierten UND-Gatters (U4) verbunden sind und ein Ausgangsanschluss des ODER-Gatters (U5) elektrisch mit der Steuerung verbunden ist, sodass, wenn beliebige zwei von dem ersten Überstromsignal, dem ersten Gleichtaktstromsignal und dem ersten Spannung-gegen-Masse-Signal an den Eingangsanschlüssen mindestens eines von dem zweiten UND-Gatter (U2), dem dritten UND-Gatter (U3) und dem vierten UND-Gatter (U4) vorhanden sind, das ODER-Gatter (U5) dazu konfiguriert ist, das erste Fehlersignal an dem Ausgangsanschluss des ODER-Gatters (U5) zu erzeugen; und wenn beliebige zwei von dem zweiten Überstromsignal, dem zweiten Gleichtaktstromsignal und dem zweiten Spannung-gegen-Masse-Signal an den Eingangsanschlüssen mindestens eines von dem zweiten UND-Gatter (U2), dem dritten UND-Gatter (U3) und dem vierten UND-Gatter (U4) vorhanden sind, das ODER-Gatter (U5) dazu konfiguriert ist, das zweite Fehlersignal an dem Ausgangsanschluss des ODER-Gatters (U5) zu erzeugen.

2. Schutzschaltung nach Anspruch 1, wobei der Brückenarm einen oberen Brückenarm und einen unteren Brückenarm umfasst; und
die Steuerung dazu konfiguriert ist, die mit dem oberen Brückenarm parallel geschaltete steuerbare Leistungsvorrichtung (Q) beim Empfangen des ersten Fehlersignals so zu steuern, dass sie eingeschaltet ist, und/oder die mit dem unteren Brückenarm parallel geschaltete steuerbare Leistungsvorrichtung (Q) beim Empfangen des zweiten Fehlersignals so zu steuern, dass sie eingeschaltet ist.

3. Schutzschaltung nach Anspruch 1, wobei das Signalumwandlungsmodul ferner umfasst:
eine Datenfiltereinheit (442), wobei ein Eingangsanschluss der Datenfiltereinheit (442) elektrisch mit einem Ausgangsanschluss des Überstromerkennungsmoduls (410), einem Ausgangsanschluss des Gleichtaktstromerkennungsmoduls (420) und einem Ausgangsanschluss des Spannungserkennungsmoduls (430) verbunden ist und die Datenfiltereinheit (442) dazu konfiguriert ist, das erste Überstromsignal, das zweite Überstromsignal, das erste Gleichtaktstromsignal, das zweite Gleichtaktstromsignal, das erste Spannung-gegen-Masse-Signal und/oder das zweite Spannung-gegen-Masse-Signal zu filtern.

4. Schutzschaltung nach einem der Ansprüche 1 bis 3, wobei die Relaisbaugruppe (K) mehrere in Reihe geschaltete Relais umfasst; und die Steuerung elektrisch mit den Relais verbunden und dazu konfiguriert ist, mindestens zwei Relaistrennsequenzen zu verwenden, wenn die Relaisbaugruppe (K) wiederholt getrennt wird; und
die Relaisbaugruppe (K) ein erstes Relais (K1) und ein zweites Relais (K2), die in Reihe geschaltet sind, umfasst; und die Steuerung dazu konfiguriert ist, die folgenden Vorgänge abwechselnd auszuführen: Trennen des ersten Relais (K1) vor dem zweiten Relais (K2); oder Trennen des zweiten Relais (K2) vor dem ersten Relais (K1).

5. Schutzschaltung nach einem der Ansprüche 1 bis 3, wobei die steuerbare Leistungsvorrichtung (Q) Silizium-gesteuerte Gleichrichter (SCRs) umfasst, die Ausgangsphasen der Dreiphasen-Wechselrichterschaltung (300) entsprechen;
jeder SCR zwischen der Anode der Stromversorgungsbaugruppe (100) und dem Brückenarm jeder Phase vorgesehen ist; und wenn die Anode der Stromversorgungsbaugruppe (100) geerdet ist, die steuerbare Leistungsvorrichtung (Q) gestartet wird und der SCR eingeschaltet wird, um einen Strom von der Anode der Stromversorgungsbaugruppe (100) zu einer Schaltvorrichtung abzuzweigen, wobei die Schaltvorrichtung zwischen den Brückenarmen der Phasen auf einer Wechselstrom-(AC)-Seite der Dreiphasen-Wechselrichterschaltung (300) liegt; oder
jeder SCR zwischen der Kathode der Stromversorgungsbaugruppe (100) und dem Brückenarm jeder Phase vorgesehen ist; und wenn die Kathode der Stromversorgungsbaugruppe (100) geerdet ist, die steuerbare Leistungsvorrichtung (Q) gestartet wird und der SCR eingeschaltet wird, um einen Strom von der Kathode der Stromversorgungsbaugruppe (100) zu einer Schaltvorrichtung abzuzweigen, wobei die Schaltvorrichtung zwischen den Brückenarmen der Phasen auf der AC-Seite der Dreiphasen-Wechselrichterschaltung (300) liegt.

6. Schutzschaltung nach einem der Ansprüche 1 bis 3, wobei die Steuerung umfasst:
ein Vortrennmodul, das dazu konfiguriert ist, nach Empfangen des Fehlersignals in eine Vortrennstufe einzutreten und eine Nulldurchgangszeit zu bestimmen, wenn der Ausstrom jeder Phase in der Dreiphasen-Wechselrichterschaltung (300) zum ersten Mal einen Nullpunkt durchläuft; und
ein Haupttrennmodul, das dazu konfiguriert ist, nach der Vortrennstufe in eine Haupttrennstufe einzutreten und die Relaisbaugruppe (K) einer entsprechenden Phase zu trennen, wenn jede Phase mindestens eine der folgenden Bedingungen erfüllt:
eine Zeitdifferenz zwischen der gegenwärtigen Zeit und der Nulldurchgangszeit kleiner als ein Schwellenwert ist; oder
der Ausgangsstrom kleiner als ein fünfter Stromschwellenwert ist.

7. Schutzschaltung nach Anspruch 6, wobei die Dreiphasen-Wechselrichterschaltung (300) ein Dreiphasen-Vierleitersystem verwendet; und das Haupttrennmodul ferner dazu konfiguriert ist, nach der Vortrennstufe in die Haupttrennstufe einzutreten und die Relaisbaugruppe (K) der entsprechenden Phase zu trennen, wenn jede Phase mindestens eine der folgenden Bedingungen erfüllt:
die Zeitdifferenz zwischen der gegenwärtigen Zeit und der Nulldurchgangszeit kleiner als der Schwellenwert ist;
der Ausgangsstrom kleiner als der fünfte Stromschwellenwert ist; oder
ein Winkel einer Phasenspannung innerhalb eines Zielwinkelbereichs liegt, wobei
wenn der Anoden-STG-Fehler auftritt, der Zielwinkelbereich [180°, 180+θ1°] ist; und wenn der Kathoden-STG-Fehler auftritt, der Zielwinkelbereich [0°, θ₂°], ist, wobei θ₁ ein erster Winkelschwellenwert und θ₂ ein zweiter Winkelschwellenwert ist.

8. Ein Steuerverfahren zum Betreiben einer Schutzschaltung nach einem der Ansprüche 1-7, wobei das Steuerverfahren auf eine Dreiphasen-Wechselrichterschaltung (300) angewendet wird; eine Gleichstrom-(DC)-Seite der Dreiphasen-Wechselrichterschaltung (300) dazu konfiguriert ist, eine Stromversorgungsbaugruppe (100) anzuschließen; ein Ausgangsanschluss jeder Phase in der Dreiphasen-Wechselrichterschaltung (300) mit einer Relaisbaugruppe (K) versehen ist; ein Brückenarm in der Dreiphasen-Wechselrichterschaltung (300) mit einer steuerbaren Leistungsvorrichtung (Q) parallel geschaltet ist; und das Steuerverfahren umfasst:
Schritt 10: Steuern der steuerbaren Leistungsvorrichtung (Q) derart, dass sie eingeschaltet ist, wenn ein Kurzschluss-gegen-Masse-(STG)-Fehler der Stromversorgungsbaugruppe (100) erkannt wird;
Schritt 20: Erkennen eines Ausgangsstroms jeder Phase in der Dreiphasen-Wechselrichterschaltung (300); und
Schritt 30: Trennen der Relaisbaugruppe (K) jeder Phase, nachdem die steuerbare Leistungsvorrichtung (Q) eingeschaltet ist und wenn der Ausgangsstrom jeder Phase eine Nulldurchgangsbedingung erfüllt.

9. Steuerverfahren nach Anspruch 8, wobei das Trennen der Relaisbaugruppe (K) jeder Phase, wenn der Ausgangsstrom jeder Phase eine Nulldurchgangsbedingung erfüllt, umfasst:
in einer ersten Stufe Bestimmen einer Nulldurchgangszeit, wenn der Ausgangsstrom jeder Phase in der Dreiphasen-Wechselrichterschaltung (300) zum ersten Mal einen Nullpunkt durchläuft; und
in einer zweiten Stufe Trennen der Relaisbaugruppe (K) einer entsprechenden Phase, wenn jede Phase mindestens eine der folgenden Bedingungen erfüllt:
eine Zeitdifferenz zwischen der gegenwärtigen Zeit und der Nulldurchgangszeit kleiner als ein Schwellenwert ist; oder
der Ausgangsstrom kleiner als ein fünfter Stromschwellenwert ist.

10. Steuerverfahren nach Anspruch 9, wobei die Dreiphasen-Wechselrichterschaltung (300) ein Dreiphasen-Vierleitersystem verwendet und das Steuerverfahren ferner umfasst:
Erfassen eines Winkels jeder Phasenspannung; und
in der zweiten Stufe Trennen der Relaisbaugruppe (K) der entsprechenden Phase, wenn jede Phase mindestens eine der folgenden Bedingungen erfüllt:
die Zeitdifferenz zwischen der gegenwärtigen Zeit und der Nulldurchgangszeit kleiner als der Schwellenwert ist;
der Ausgangsstrom kleiner als der fünfte Stromschwellenwert ist; oder
der Winkel der Phasenspannung innerhalb eines Zielwinkelbereichs liegt, wobei
wenn ein Anoden-STG-Fehler auftritt, der Zielwinkelbereich [180°, 180+θ1°] ist; und wenn ein Kathoden-STG-Fehler auftritt, der Zielwinkelbereich [0°, θ2°] ist, wobei θ1 ein erster Winkelschwellenwert und θ2 ein zweiter Winkelschwellenwert ist.

11. Steuerverfahren nach Anspruch 8, wobei der Brückenarm der Dreiphasen-Wechselrichterschaltung (300) einen oberen Brückenarm umfasst; und das Steuern der steuerbaren Leistungsvorrichtung (Q) derart, dass sie eingeschaltet ist, wenn der STG-Fehler erkannt wird, umfasst:
wenn das erste Fehlersignal gemäß dem Signalumwandlungsmodul erzeugt wird, Bestimmen eines Anoden-STG-Fehlers der Stromversorgungsbaugruppe (100); und als Reaktion auf den Anoden-STG-Fehler der Stromversorgungsbaugruppe (100) Steuern der mit dem oberen Brückenarm parallel geschalteten steuerbaren Leistungsvorrichtung (Q) derart, dass sie eingeschaltet ist.

12. Steuerverfahren nach Anspruch 8, wobei der Brückenarm der Dreiphasen-Wechselrichterschaltung (300) einen unteren Brückenarm umfasst; und das Steuern der steuerbaren Leistungsvorrichtung (Q) derart, dass sie eingeschaltet ist, wenn der STG-Fehler erkannt wird, umfasst:
wenn das zweite Fehlersignal gemäß dem Signalumwandlungsmodul erzeugt wird, Bestimmen eines Kathoden-STG-Fehlers der Stromversorgungsbaugruppe (100); und als Reaktion auf den Kathoden-STG-Fehler der Stromversorgungsbaugruppe (100) Steuern der mit dem unteren Brückenarm parallel geschalteten steuerbaren Leistungsvorrichtung (Q) derart, dass sie eingeschaltet ist.

13. Ein Photovoltaiksystem, umfassend eine Stromversorgungsbaugruppe (100) und einen Wechselrichter, wobei der Wechselrichter eine Gleichstrom-(DC)-Seite umfasst, die dazu konfiguriert ist, die Stromversorgungsbaugruppe (100) anzuschließen, und eine Wechselstrom-(AC)-Seite, die dazu konfiguriert ist, ein Stromnetz anzuschließen; und der Wechselrichter die Schutzschaltung nach einem der Ansprüche 1 bis 7 umfasst.

## Revendications

1. Circuit de protection, dans lequel le circuit de protection est appliqué à un circuit onduleur triphasé (300) ; un côté courant continu (CC) du circuit onduleur triphasé (300) est configuré pour connecter un ensemble d'alimentation électrique (100) ; une borne de sortie de chaque phase dans le circuit onduleur triphasé (300) est pourvue d'un ensemble relais (K) ; et le circuit de protection comprend :
un dispositif de puissance commandable (Q) en connexion parallèle avec un bras de pont dans le circuit onduleur triphasé (300) ;
un module de détection de défaut connecté électriquement au circuit onduleur triphasé (300), et configuré pour générer un premier signal de défaut lors de la détection d'un défaut de court-circuit avec la terre, STG, à l'anode de l'ensemble d'alimentation électrique (100), et/ou générer un deuxième signal de défaut lors de la détection d'un défaut STG à la cathode de l'ensemble d'alimentation électrique (100) ;
un circuit de détection de courant (500) connecté électriquement au circuit onduleur triphasé (300), et configuré pour détecter un courant de sortie de chaque phase dans le circuit onduleur triphasé (300) ; et
une unité de commande connectée électriquement au module de détection de défaut, au circuit de détection de courant (500) et à l'ensemble relais (K),
et configuré pour commander le dispositif de puissance commandable (Q) pour qu'il soit activé après réception du premier signal de défaut et déconnecter l'ensemble relais (K) de chaque phase lorsque le courant de sortie de chaque phase satisfait une condition de passage par zéro ;
dans lequel le module de détection de défaut comprend : un module de détection de surintensité (410) connecté électriquement au circuit de détection de courant (500), et configuré pour générer un premier signal de surintensité au niveau d'une borne de sortie du module de détection de surintensité (410) lorsqu'un courant de sortie négatif d'au moins une phase est supérieur à un premier seuil de courant, et/ou générer un deuxième signal de surintensité au niveau d'une borne de sortie du module de détection de surintensité (410) lorsqu'un courant de sortie positif d'au moins une phase est supérieur à un deuxième seuil de courant ; un module de détection de courant en mode commun (420) connecté électriquement au côté CC du circuit onduleur triphasé (300), et configuré pour générer un premier signal de courant en mode commun au niveau d'une borne de sortie du module de détection de courant en mode commun (420) lorsqu'un courant en mode commun négatif au niveau du côté CC du circuit onduleur triphasé (300) est supérieur à un troisième seuil de courant, et/ou générer un deuxième signal de courant en mode commun au niveau d'une borne de sortie du module de détection de courant en mode commun (420) lorsqu'un courant en mode commun positif au niveau du côté CC du circuit onduleur triphasé (300) est supérieur à un quatrième seuil de courant ;
**caractérisé en ce que** :
le module de détection de défaut comprend en outre un module de détection de tension (430) connecté électriquement à une anode de l'ensemble d'alimentation électrique (100), une cathode de l'ensemble d'alimentation électrique (100) et un nœud de mise à la terre, et configuré pour générer un premier signal tension par rapport à la terre au niveau d'une borne de sortie du module de détection de tension (430) lorsqu'une tension par rapport à la terre entre l'anode de l'ensemble d'alimentation électrique (100) et le nœud de mise à la terre est inférieure à un premier seuil de tension, et/ou générer un deuxième signal tension par rapport à la terre au niveau de la borne de sortie du module de détection de tension (430) lorsqu'une tension par rapport à la terre entre la cathode de l'ensemble d'alimentation électrique (100) et le nœud de mise à la terre est inférieure à un deuxième seuil de tension ; et un module de conversion de signal connecté électriquement au module de détection de surintensité (410), au module de détection de courant en mode commun (420) et au module de détection de tension (430) ;
dans lequel le module de conversion de signal comprend : une première porte ET (U1), dans lequel des bornes d'entrée de la première porte ET (U1) sont respectivement connectées électriquement à la borne de sortie du module de détection de surintensité (410), à la borne de sortie du module de détection de courant en mode commun (420) et à la borne de sortie du module de détection de tension (430), et une borne de sortie de la première porte ET (U1) est connectée électriquement à l'unité de commande, de telle sorte que, lorsque trois parmi le premier signal de surintensité, le premier signal de courant en mode commun et le premier signal tension par rapport à la terre sont présents au niveau des bornes d'entrée de la première porte ET (U1), la première porte ET (U1) est configurée pour générer le premier signal de défaut au niveau de la borne de sortie de la première porte ET (U1) ; et lorsque trois parmi le deuxième signal de surintensité, le deuxième signal de courant en mode commun et le deuxième signal tension par rapport à la terre sont présents au niveau des bornes d'entrée de la première porte ET (U1), la première porte ET (U1) est configurée pour générer le deuxième signal de défaut au niveau de la borne de sortie de la première porte ET (U1) ; ou, le module de conversion de signal comprend : une deuxième porte ET (U2), dans lequel des bornes d'entrée de la deuxième porte ET (U2) sont respectivement connectées électriquement à la borne de sortie du module de détection de surintensité (410) et à la borne de sortie du module de détection de courant en mode commun (420) ; une troisième porte ET (U3), dans lequel des bornes d'entrée de la troisième porte ET (U3) sont respectivement connectées électriquement à la borne de sortie du module de détection de surintensité (410) et à la borne de sortie du module de détection de tension (430) ; une quatrième porte ET (U4), dans lequel des bornes d'entrée de la quatrième porte ET (U4) sont respectivement connectées électriquement à la borne de sortie du module de détection de courant en mode commun (420) et à la borne de sortie du module de détection de tension (430) ; et une porte OU (U5), dans lequel des bornes d'entrée de la porte OU (U5) sont respectivement connectées électriquement à une borne de sortie de la deuxième porte ET (U2), à une borne de sortie de la troisième porte ET (U3) et à une borne de sortie de la quatrième porte ET (U4), et une borne de sortie de la porte OU (U5) est connectée électriquement à l'unité de commande, de telle sorte que, lorsque deux quelconques parmi le premier signal de surintensité, le premier signal de courant en mode commun et le premier signal tension par rapport à la terre sont présents au niveau des bornes d'entrée d'au moins l'une parmi la deuxième porte ET (U2), la troisième porte ET (U3) et la quatrième porte ET (U4), la porte OU (U5) est configurée pour générer le premier signal de défaut au niveau de la borne de sortie de la porte OU (U5) ; et lorsque deux quelconques parmi le deuxième signal de surintensité, le deuxième signal de courant en mode commun et le deuxième signal tension par rapport à la terre sont présents au niveau des bornes d'entrée d'au moins deux parmi la deuxième porte ET (U2), la troisième porte ET (U3) et la quatrième porte ET (U4), la porte OU (U5) est configurée pour générer le deuxième signal de défaut au niveau de la borne de sortie de la porte OU (U5).

2. Circuit de protection selon la revendication 1, dans lequel le bras de pont comprend un bras de pont supérieur et un bras de pont inférieur ; et
l'unité de commande est configurée pour commander le dispositif de puissance commandable (Q) en connexion parallèle avec le bras de pont supérieur pour qu'il soit activé lors de la réception du premier signal de défaut, et/ou commander le dispositif de puissance commandable (Q) en connexion parallèle avec le bras de pont inférieur pour qu'il soit activé lors de la réception du deuxième signal de défaut.

3. Circuit de protection selon la revendication 1, dans lequel le module de conversion de signal comprend en outre :
une unité de filtrage de données (442), dans lequel une borne d'entrée de l'unité de filtrage de données (442) est connectée électriquement à une borne de sortie du module de détection de surintensité (410), à une borne de sortie du module de détection de courant en mode commun (420) et à une borne de sortie du module de détection de tension (430), et l'unité de filtrage de données (442) est configurée pour filtrer le premier signal de surintensité, le deuxième signal de surintensité, le premier signal de courant en mode commun, le deuxième signal de courant en mode commun, le premier signal tension par rapport à la terre et/ou le deuxième signal tension par rapport à la terre.

4. Circuit de protection selon l'une quelconque des revendications 1 à 3, dans lequel l'ensemble relais (K) comprend une pluralité de relais connectés en série ; et l'unité de commande est connectée électriquement aux relais, et configurée pour utiliser au moins deux séquences de déconnexion de relais lors de la déconnexion répétitive de l'ensemble relais (K) ; et
l'ensemble relais (K) comprend un premier relais (K1) et un deuxième relais (K2) connectés en série ; et l'unité de commande est configurée pour exécuter les opérations suivantes en alternance : déconnexion du premier relais (K1) avant le deuxième relais (K2) ; ou déconnexion du deuxième relais (K2) avant le premier relais (K1).

5. Circuit de protection selon l'une quelconque des revendications 1 à 3, dans lequel le dispositif de puissance commandable (Q) comprend des redresseurs commandés au silicium (SCR) correspondant à des phases de sortie du circuit onduleur triphasé (300) ;
chaque SCR est ménagé entre l'anode de l'ensemble d'alimentation électrique (100) et le bras de pont de chaque phase ; et lorsque l'anode de l'ensemble d'alimentation électrique (100) est mise à la terre, le dispositif de puissance commandable (Q) est démarré, et le SCR est activé pour dériver un courant de l'anode de l'ensemble d'alimentation électrique (100) vers un dispositif de commutation, dans lequel le dispositif de commutation se trouve entre les bras de pont des phases au niveau d'un côté courant alternatif (CA) du circuit onduleur triphasé (300) ; ou
chaque SCR est ménagé entre la cathode de l'ensemble d'alimentation électrique (100) et le bras de pont de chaque phase ; et lorsque la cathode de l'ensemble d'alimentation électrique (100) est mise à la terre, le dispositif de puissance commandable (Q) est démarré, et le SCR est activé pour dériver un courant de la cathode de l'ensemble d'alimentation électrique (100) vers un dispositif de commutation, dans lequel le dispositif de commutation se trouve entre les bras de pont des phases au niveau du côté CA du circuit onduleur triphasé (300).

6. Circuit de protection selon l'une quelconque des revendications 1 à 3, dans lequel l'unité de commande comprend :
un module de coupure préliminaire, configuré pour entrer dans un stade de coupure préliminaire après réception du signal de défaut, et déterminer un instant de passage par zéro lorsque le courant de sortie de chaque phase dans le circuit onduleur triphasé (300) passe par un point zéro pour une première fois ; et
un module de coupure principal, configuré pour entrer dans un stade de coupure principal après l'étape de coupure préliminaire, et déconnecter l'ensemble relais (K) d'une phase correspondante lorsque chaque phase satisfait au moins l'une des conditions suivantes :
une différence de temps entre l'instant présent et l'instant de passage par zéro est inférieure à un seuil ; ou,
le courant de sortie est inférieur à un cinquième seuil de courant.

7. Circuit de protection selon la revendication 6, dans lequel le circuit onduleur triphasé (300) utilise un système triphasé à quatre fils ; et le module de coupure principal est en outre configuré pour entrer dans le stade de coupure principal après le stade de coupure préliminaire, et déconnecter l'ensemble relais (K) de la phase correspondante lorsque chaque phase satisfait au moins l'une des conditions suivantes :
la différence de temps entre l'instant présent et l'instant de passage par zéro est inférieure au seuil ;
le courant de sortie est inférieur au cinquième seuil de courant ; ou,
un angle d'une tension de phase tombe dans une plage d'angle cible, dans lequel
lorsque le défaut STG à l'anode se produit, la plage d'angle cible est [180°, 180+θ₁°] ; et lorsque le défaut STG à la cathode se produit, la plage d'angle cible est [0°, θ₂°], θ₁ étant un premier seuil d'angle, et θ₂ étant un deuxième seuil d'angle.

8. Procédé de commande du fonctionnement d'un circuit de protection selon l'une quelconque des revendications 1-7, dans lequel le procédé de commande est appliqué à un circuit onduleur triphasé (300) ; un côté courant continu (CC) du circuit onduleur triphasé (300) est configuré pour connecter un ensemble d'alimentation électrique (100) ; une borne de sortie de chaque phase dans le circuit onduleur triphasé (300) est pourvue d'un ensemble relais (K) ; un bras de pont dans le circuit onduleur triphasé (300) est en connexion parallèle avec un dispositif de puissance commandable (Q) ; et le procédé de commande comprend :
Étape 10 : la commande du dispositif de puissance commandable (Q) pour qu'il soit activé lorsqu'un défaut de court-circuit avec la terre (STG) de l'ensemble d'alimentation électrique (100) est détecté ;
Étape 20 : la détection d'un courant de sortie de chaque phase dans le circuit onduleur triphasé (300) ; et
Étape 30 : la déconnexion de l'ensemble relais (K) de chaque phase après activation du dispositif de puissance commandable (Q) et lorsque le courant de sortie de chaque phase satisfait une condition de passage par zéro.

9. Procédé de commande selon la revendication 8, dans lequel la déconnexion de l'ensemble relais (K) de chaque phase lorsque le courant de sortie de chaque phase satisfait une condition de passage par zéro comprend :
dans un premier stade, la détermination de l'instant de passage par zéro lorsque le courant de sortie de chaque phase dans le circuit onduleur triphasé (300) passe par un point zéro pour une première fois ; et
dans un deuxième stade, la déconnexion de l'ensemble relais (K) d'une phase correspondante, lorsque chaque phase satisfait au moins l'une des conditions suivantes :
une différence de temps entre l'instant présent et l'instant de passage par zéro est inférieure à un seuil ; ou,
le courant de sortie est inférieur à un cinquième seuil de courant.

10. Procédé de commande selon la revendication 9, dans lequel le circuit onduleur triphasé (300) utilise un système triphasé à quatre fils, et le procédé de commande comprend en outre :
l'acquisition d'un angle de chaque tension de phase ; et
dans le deuxième étage, la déconnexion de l'ensemble relais (K) de la phase correspondante, lorsque chaque phase satisfait au moins l'une des conditions suivantes :
la différence de temps entre l'instant présent et l'instant de passage par zéro est inférieure au seuil ;
le courant de sortie est inférieur au cinquième seuil de courant ; ou,
l'angle de la tension de phase tombe dans une plage d'angle cible, dans lequel
lorsqu'un défaut STG à l'anode se produit, la plage d'angle cible est [180°, 180+θ₁°] ; et lorsqu'un défaut STG à la cathode se produit, la plage d'angle cible est [0°, θ₂°], θ₁ étant un premier seuil d'angle, et θ₂ étant un deuxième seuil d'angle.

11. Procédé de commande selon la revendication 8, dans lequel le bras de pont du circuit onduleur triphasé (300) comprend un bras de pont supérieur ; et la commande du dispositif de puissance commandable (Q) pour qu'il soit activé lors de la détection du défaut STG comprend :
lorsque le premier signal de défaut est généré selon le module de conversion de signal, la détermination d'un défaut STG à l'anode de l'ensemble d'alimentation électrique (100) ; et en réponse au défaut STG à l'anode de l'ensemble d'alimentation électrique (100), la commande du dispositif de puissance commandable (Q) en connexion parallèle avec le bras de pont supérieur pour qu'il soit activé.

12. Procédé de commande selon la revendication 8, dans lequel le bras de pont du circuit onduleur triphasé (300) comprend un bras de pont inférieur ; et la commande du dispositif de puissance commandable (Q) pour qu'il soit activé lors de la détection du défaut STG comprend :
lorsque le deuxième signal de défaut est généré selon le module de conversion de signal, la détermination d'un défaut STG à la cathode de l'ensemble d'alimentation électrique (100) ; et en réponse au défaut STG à la cathode de l'ensemble d'alimentation électrique (100), la commande du dispositif de puissance commandable (Q) en connexion parallèle avec le bras de pont inférieur pour qu'il soit activé.

13. Système photovoltaïque, comprenant un ensemble d'alimentation électrique (100) et un onduleur, dans lequel l'onduleur comprend un côté courant continu (CC) configuré pour connecter l'ensemble d'alimentation électrique (100), et un côté courant alternatif (CA) configuré pour connecter un réseau électrique ; et l'onduleur comprend le circuit de protection selon l'une quelconque des revendications 1 à 7.
